(19) Europäisches Patentamt
European Patent Office
Office européen des brevets

(11) **EP 4 174 923 A1**

(12) **EUROPÄISCHE PATENTANMELDUNG**

(43) Veröffentlichungstag:
**03.05.2023 Patentblatt 2023/18**

(21) Anmeldenummer: **21204923.3**

(22) Anmeldetag: **27.10.2021**

(51) Internationale Patentklassifikation (IPC):
**H01L 21/768** (2006.01) **B81C 1/00** (2006.01)
**H01L 23/48** (2006.01)

(52) Gemeinsame Patentklassifikation (CPC):
**H01L 21/76898; B81C 1/00095; H01L 23/481;**
H01L 21/7682

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Hahn-Schickard-Gesellschaft für angewandte
Forschung e.V.
78052 Villingen-Schwenningen (DE)**

(72) Erfinder:
• **Dehé, Alfons
72770 Reutlingen (DE)**
• **Nommensen, Peter
78054 Villingen-Schwenningen (DE)**
• **Auber, Johannes
78052 Villingen-Schwennigen (DE)**

(74) Vertreter: **Hertin und Partner
Rechts- und Patentanwälte PartG mbB
Kurfürstendamm 54/55
10707 Berlin (DE)**

(54) **HERMETISCHE DURCHKONTAKTIERUNGEN MIT NIEDRIGEREN PARASITÄREN KAPAZITÄTEN**

(57) In einem ersten Aspekt betrifft die Erfindung ein Verfahren zur Herstellung einer Durchkontaktierung für ein Halbleiterbauteil. Das Halbleiterbauteil umfasst dabei einen Durchkontaktierungsbereich, der von vertikalen Gräben umschlossen ist. Die vertikalen Gräben sind hierbei mit einem Dielektrikum lediglich partiell befüllt, sodass insbesondere die auftretenden parasitären Kapazitäten erheblich verringert worden sind.

In einem zweiten Aspekt betrifft die Erfindung ein Halbleiterbauteil, welches mit dem erfindungsgemäßen Verfahren hergestellt wurde.

Fig. 1
Q

EP 4 174 923 A1

**Beschreibung**

## BESCHREIBUNG

In einem ersten Aspekt betrifft die Erfindung ein Verfahren zur Herstellung einer Durchkontaktierung für ein Halbleiterbauteil. Das Halbleiterbauteil umfasst dabei einen Durchkontaktierungsbereich, der von vertikalen Gräben umschlossen ist. Die vertikalen Gräben sind mit einem Dielektrikum lediglich partiell befüllt, sodass insbesondere die auftretenden parasitären Kapazitäten erheblich verringert werden.

In einem weiteren Aspekt betrifft die Erfindung ein Halbleiterbauteil, welches mit dem erfindungsgemäßen Verfahren hergestellt wurde.

Hintergrund und Stand der Technik

Durchkontaktierungen (engl. vias) bezeichnen vertikale elektrische Verbindungen zwischen Leiterbahnebenen, wie sie häufig in Halbleiterbauteilen vorzufinden sind. Durchkontaktierungen finden sich insbesondere in integrierten Schaltkreisen. In der modernen Halbleitertechnologie sind sie ein integraler Bestandteil. Da häufig in der Halbleitertechnologie Wafer umfassend Silizium verwendet werden, stellen Silizium-Durchkontaktierungen (engl. *through silicon vias,* kurz TSV) eine verbreitete Art der Durchkontaktierungen dar. Insbesondere können Silizium-Durchkontaktierungen vertikale elektrische Verbindungen zwischen gestapelten Mikrochips bei 3D-integrierten Schaltkreisen ermöglichen. Vor allem können auch MEMS-Bauteile innerhalb des Silizium-Wafers oder innerhalb eines Waferstacks betrieben werden. Silizium-Durchkontaktierungen stellen daher eine bewährte Technologie dar, um hohe Anforderungen an die elektrischen Pfade in Bezug auf deren kurze Länge, Robustheit und Langlebigkeit zu gewährleisten.

Im Stand der Technik sind verschiedene Vorrichtungen und Verfahren bekannt, die Silizium-Durchkontaktierungen umfassen und für einen Betrieb nutzen. Einige dieser im Stand der Technik bekannten Vorrichtungen und Verfahren werden im Folgenden kurz beschrieben.

US 2005/0250238 A1 offenbart ein Verfahren, um ein MEMS-Bauteil auf einem Substrat umfassend Silizium hermetisch abzuriegeln. Dazu werden Gräben bis hinunter zu einem Isolator geätzt und dann mit Siliziumnitrid gefüllt, um einen inneren Block aus Silizium von dem umgebenden Substrat elektrisch zu isolieren. Das Siliziumnitrid füllt die Gräben, bedeckt die Oberfläche des Substrats und isoliert auch Oberseite des Siliziumblocks.

US 8,433,084 B2 offenbart einen MEMS-Schallwandler, insbesondere MEMS-Mikrofone, innerhalb eines Waferstacks. Durch die Durchkontaktierungen, welche an Kontaktierhügel (engl. bumps), die wiederum an Kontaktpads verbunden sind, werden durch Schall verursachte elektrische Signale an elektrische Verbindungen weitergeleitet. Die Durchkontaktierungen verlaufen durch ein Substrat, wobei das Substrat isolierendes Material umfasst, beispielsweise organisches Material. Zudem befinden sich die Durchkontaktierungen außerhalb des MEMS-Bereichs.

DE 102007063742 B4 offenbart einen Sensor, der als Drucksensor und/oder Beschleunigungssensor ausgeführt sein kann. Dabei führt eine Durchdringungselektrode, die die Durchkontaktierung zu einer Verdrahtungsleitung bildet. Die Durchdringungselektrode ist von einem Isolationsfilm umgeben. Der Isolationsfilm isoliert die Durchdringungselektrode von einem Drucksensorsubstrat und/oder einer Membran. Dieser Isolationsfilm wird durch thermische Oxidation gebildet und umgibt die Durchdringungselektrode vollständig.

Den im Stand der Technik bekannten Durchkontaktierungen ist gemein, dass parasitäre Kapazitäten auftreten können. Parasitäre Kapazitäten können nachteilige technische Effekte hervorrufen. Hierbei können beispielsweise durch Strahlung oder eine erhöhte Temperatur, Leckströme entstehen, die das Halbleiterbauteil beschädigen oder sogar funktionsuntüchtig machen könnten. Insbesondere zeigen sich die Auswirkungen von parasitären Kapazitäten in Form einer Beeinflussung von hochfrequenten Spannungs- und Stromoszillationen nach Schaltvorgängen von Halbleiterbauteilen. Sobald durch ein Einschalten die Spannung einer Potentialfläche gegenüber einem Bezugspotential sinkt, entlädt sich die parasitäre Kapazität der Potentialfläche. Dies führt zu einem Überschwingen am Ende von Spannungssignalflanken. Zudem können die Kapazitäten mit parasitären Induktivitäten des Aufbaus koppeln und hochfrequente gedämpfte Oszillationen verursachen.

Parasitäre Kapazitäten, auch als Streukapazitäten bekannt, sind für gewöhnlich unerwünschte Kapazitäten, die zwischen Bestandteilen von elektronischen Komponenten oder einer elektronischen Schaltung, insbesondere aufgrund ihrer Nähe zueinander, auftreten. Wenn zwei elektrische Leiter mit unterschiedlichen Spannungen nahe beieinander liegen, bewirkt das elektrische Feld zwischen ihnen, dass elektrische Ladung auf ihnen gespeichert wird. Dieser Effekt wird auch als eine parasitäre Kapazität bezeichnet. Alle tatsächlichen Schaltungselemente wie Induktoren, Dioden, Transistoren usw. haben eine interne Kapazität, die dazu führen kann, dass ihr Verhalten von dem der "idealen" Schaltungselemente abweicht. Der Einfluss von Streukapazitäten nimmt mit steigender Frequenz zu. Neben dem Abstand, der Fläche und der Frequenz ist die Streukapazität insbesondere von der Permittivität

$$\varepsilon = \varepsilon_0 \varepsilon_r$$

abhängig, wobei $\varepsilon_0$ die elektrische Feldkonstante und $\varepsilon_r$ die relative Permittivität eines Mediums (Bezeichnung nach Norm DKE-IEV 121-12-13) bezeichnet. Synonym zum Begriff der relativen Permittivität kann auch der Begriff der Dielektrizitätszahl verwendet werden.

Im Hinblick auf eine Reduktion parasitärer Kapazitäten besteht in Bezug auf bekannte HalbleiterBauelemente mit Durchkontaktierungen ein erhebliches Verbesserungspotential.

## Aufgabe der Erfindung

Aufgabe der Erfindung ist es, eine Vorrichtung bzw. ein Verfahren zur Herstellung von Durchkontaktierungen bereitzustellen, welche die Nachteile des Standes der Technik beseitigen. Insbesondere ist es eine Aufgabe der Erfindung, Durchkontaktierungen mit minimalen parasitären Kapazitäten herzustellen. Zudem sollen die Durchkontaktierungen hermetisch abgeriegelt sein. Das Herstellungsverfahren sollte zudem einfach, kostengünstig und massentauglich sein, um Anwendungen in verschiedensten Bereichen zu ermöglichen.

## Zusammenfassung der Erfindung

Die Aufgabe wird durch die Merkmale der unabhängigen Ansprüche gelöst. Bevorzugte Ausführungsformen der Erfindung sind in den abhängigen Ansprüchen beschrieben.

In einem ersten Aspekt betrifft die Erfindung ein Verfahren zur Herstellung einer Durchkontaktierung für ein Halbleiterbauteil umfassend mindestens einen Wafer, umfassend die nachfolgenden Schritte:

> a) Bilden von vertikalen Gräben innerhalb des Wafers, welche einen Durchkontaktierungsbereich umschließen
> b) Auskleiden und Verschließen der vertikalen Gräben mit einem Dielektrikum, wobei die vertikalen Gräben lediglich partiell mit dem Dielektrikum befüllt werden
> c) Anschluss des Durchkontaktierungsbereiches mit einer elektrischen Verbindung.

Die Durchkontaktierungen, die mittels des erfindungsgemäßen Herstellungsverfahrens gebildet worden sind, haben sich in vielerlei Aspekten als sehr vorteilhaft erwiesen, die im Folgenden ausgeführt werden.

Besonders vorteilhaft ist der Umstand, dass die auftretenden parasitären Kapazitäten erheblich verringert werden. Dies wird im Wesentlichen dadurch erlangt, dass die vertikalen Gräben, welche den Durchkontaktierungsbereich umschließen, partiell, d. h. insbesondere nicht vollständig, mit einem Dielektrikum befüllt werden. Die parasitären Kapazitäten können horizontal und/oder vertikal zwischen dem Durchkontaktierungsbereich und weiteren Bereichen des Wafers und/oder des Halbleiterbauteils vorliegen.

Vor allem können sich parasitäre Kapazitäten zwischen zwei Durchkontaktierungen bilden, die nebeneinander verlaufen. Fließt Strom und/oder liegt eine Spannung am Durchkontaktierungsbereich an, bilden sich elektrische und/oder magnetische Felder zwischen dem Durchkontaktierungsbereich und horizontalen und/oder vertikalen Bereichen des Wafers und/oder des Halbleiterbauteils. Durch die partielle Befüllung der vertikalen Gräben mit einem Dielektrikum wird insbesondere das elektrische Feld geschwächt, denn durch die Polarisation im Dielektrikum entsteht ein entgegengesetztes elektrisches Feld. Daher endet ein Teil der Feldlinien des elektrischen Feldes in den Polarisationsladungen an der Oberfläche des Dielektrikums.

Parasitäre Kapazitäten entstehen beispielsweise, wenn zwei Leiterbahnen sich auf unterschiedlichen Ebenen kreuzen und/oder wenn zwei Leitbahnen parallel nebeneinander verlaufen. Der Kreuzungsbereich bzw. die benachbarten Leitbahnen, zwischen denen parasitäre Kapazitäten auftreten, können in einer ersten Näherung mit einem üblichen Plattenkondensator modelliert werden. Die Kapazität C eines Plattenkondensators berechnet sich über

$$C = \varepsilon_0 \varepsilon_r \frac{A}{d}, \qquad (1)$$

wobei A die Fläche und d den Abstand zwischen den "Kondensatorplatten" bezeichnet. Es ist zu erkennen, dass die Verringerung des Abstandes d die Kapazität C erhöht. Um dies auszugleichen, ist es notwendig, die Plattenfläche A oder die relative Permittivität $\varepsilon_r$ zu verringern. Der Leiterbahnquerschnitt und somit die Plattenfläche der parasitären Kapazitäten werden aber kaum verkleinert. Das liegt daran, dass die Stromdichte in den Leiterbahnen nicht steigen darf und kleinere Querschnitte den elektrischen Widerstand durch stärkeren Einfluss der Grenzflächenstreuung der Elektronen erhöhen. Daher ist es bevorzugt, die relative Permittivität $\varepsilon_r$ möglichst gering zu halten. Die Einfuhr eines Dielektrikums zwischen zwei Kondensatorplatten erhöht hingegen die Kapazität.

Erfindungsgemäß wurde erkannt, dass auftretende Kapazitäten reduziert werden können, indem die vertikalen Gräben, welche den Durchkontaktierungsbereich umschließen, partiell mit einem Dielektrikum befüllt werden. Durch die partielle Befüllung mit dem Dielektrikum wird dessen Materialdichte, insbesondere dessen Dipoldichte, gesenkt, indem freies Volumen innerhalb der vertikalen Gräben geschaffen wird. Die partielle Befüllung der vertikalen Gräben erfolgt bevorzugt dadurch, dass die Seitenwände und der Boden der vertikalen Gräben mit einem Dielektrikum beschichtet werden.

Die parasitären Kapazitäten, die im Zusammenhang mit den im Stand der Technik bekannten Durchkontaktierungen auftreten, reichen ca. von $10^{-6}$ F (Farad) bis hin zu $10^{-12}$ F. Mittels des erfindungsgemäßen Verfahrens lassen sich Durchkontaktierungen bilden, die parasitäre Kapazitäten von weniger als $10^{-12}$ F, bevorzugt weniger als $10^{-13}$ F, $10^{-14}$ F bzw. im Bereich von einigen $10^{-15}$ F oder weniger aufweisen, also im Femtofarad-Bereich.

Durch die vertikalen Gräben, die den Durchkontaktierungsbereich umschließen, wird der Durchkontaktierungsbereich hermetisch abgeriegelt. Die hermetische Abriegelung des

Durchkontaktierungsbereiches ist dahingehend von Vorteil, dass der Durchkontaktierungsbereich und die vertikalen Gräben selbst gegenüber der umgebenden Atmosphäre des Halbeiterbauteils geschützt werden. Beispielsweise sorgt die hermetische Abriegelung dafür, dass ein Fluid nicht in die vertikalen Gräben hineingelangt und die Funktionalität des Halbleiterbauteils stört. Dabei ist jedoch darauf zu achten, dass trotz der hermetischen Abriegelung eine ausreichende Wärmeabfuhr gegeben ist, damit die Bauteile nicht überhitzen.

Insbesondere sorgen die den Durchkontaktierungsbereich umschließenden partiell befüllten vertikalen Gräben für eine Isolierung des Durchkontaktierungsbereiches. Dies ist von besonderer Relevanz für die Betriebstüchtigkeit des Halbleiterbauteils. Der Durchkontaktierungsbereich soll vorzugsweise Strom zwischen verschiedenen Leiterbahnebenen leiten. Um dabei beispielsweise Kurzschlüsse und/oder Stromtransport in unerwünschten Bereichen des Halbleiterbauteils zu vermeiden, wird der Durchkontaktierungsbereich "nach außen hin" isoliert. Somit wird der elektrische Stromfluss nur auf die spannungsführenden Teile des Halbleiterbauteils begrenzt.

Aus praktischen Gründen, aber auch um der immer fortschreitenden Miniaturisierung von Mikrosystemen gerecht zu werden, ist die Bildung der vertikalen Gräben dahingehend von Vorteil, dass der Durchkontaktierungsbereich eine geringe laterale Ausweitung aufweist. Insbesondere ist der Widerstand R der Durchkontaktierung von verschiedenen Parametern, wie beispielsweise dem spezifischen Widerstand ρ, der Länge l und dem Querschnitt A, aber auch von der Temperatur T abhängig. Dies lässt sich zusammenfassen über

$$R = \rho \frac{l}{A}, \qquad (2)$$

wobei die Temperaturabhängigkeit in dieser Gleichung nicht berücksichtigt wird.

Da der spezifische Widerstand ρ eine temperaturabhängige Materialkonstante ist, ist bevorzugt das Verhältnis auf Länge l und Querschnitt A so zu wählen, dass der Widerstand R des Durchkontaktierungsbereiches selbst möglichst gering gehalten wird, um einen möglichst geringen Verlust der Stromübertragung vorzuweisen.

Zudem haben sich die hergestellten Durchkontaktierungen mittels des erfindungsgemäßen Verfahrens dahingehend als besonders vorteilhaft erwiesen, dass sie nur sehr geringe mechanische Belastungen an das umgebende Wafermaterial und/oder weiteren Bestandteilen des Halbleiterbauteils ausübt. Solche mechanischen Spannungen können die Funktionalität von benachbarten Bauelementen beeinflussen. Die Verteilung, Größe und Richtung der Spannungen sind abhängig vom Herstellungsprozess, Design und Integrität der Durchkontaktierung und der vertikalen Gräben, die den Durchkontaktierungsbereich umgeben. Insbesondere sind mechanische Spannungen zu betrachten, wenn der Durchkontaktierungsbereich mit einem Füllmaterial, wie beispielsweise Kupfer befüllt, wird. Die vertikalen Gräben, welche vorzugsweise mit einem Dielektrikum partiell befüllt werden, federn und fangen die ausgeübten mechanischen Belastungen des Durchkontaktierungsbereiches vorteilhafterweise ab. Dadurch werden die mechanischen Belastungen an benachbarten Abschnitten des Durchkontaktierungsbereiches erheblich reduziert.

Mittels des erfindungsgemäßen Verfahrens lässt sich der Durchkontaktierungsbereich auch besonders einfach mit einem MEMS-Bauteil und/oder einer elektronischen Schaltung elektrisch kontaktieren, welche sich innerhalb einer Kavität eines Wafers oder Waferstacks befinden. Der Durchkontaktierungsbereich kann auch in die Kavität des MEMS-Bauteils und/oder der elektronischen Schaltung reichen.

Es kann auch bevorzugt sein, dass das Halbleiterbauteil mehrere Durchkontaktierungsbereiche umfasst, die entsprechend von mehreren partiell befüllten vertikalen Gräben umschlossen werden. Mehrere Durchkontaktierungsbereiche können vorteilhafterweise in mehreren und unterschiedlichen Abschnitten des Halbleiterbauteils Strom transportieren. Durch die mehreren partiell befüllten vertikalen Gräben ergibt sich zudem vorteilhafterweise eine höhere Biegsamkeit des Halbleiterbauteils, sodass das Halbleiterbauteil nicht auf feste äußere Formen, beispielsweise beim Einbau in ein weiteres Gerät, räumlich eingeschränkt ist und flexibel anpassbar ist.

Im Sinne der Erfindung bezeichnet ein Halbleiterbauteil bevorzugt ein Bauelement, welches man für Schaltungen in der Elektrotechnik oder der Elektronik insbesondere in Zusammenhang mit Halbleitermaterialien verwendet. Der durchschnittliche Fachmann weiß, dass der Begriff des Halbleiterbauteils weit ausgelegt werden kann. Beispielsweise kann ein Halbleiterbauteil einen integrierten Schaltkreis umfassen, der Transistoren und/oder Dioden aufweist oder selbst ein solches Bauteil sein. Vorzugsweise erfolgt die Fertigung der integrierten Schaltkreise auf Wafern, die insbesondere ein Halbleitermaterial umfassen können, jedoch nicht darauf beschränkt sind. Zudem können durch Bearbeitung des Wafers Bauelemente wie Transistoren, Dioden und/oder Kondensatoren durch das Wafermaterial selbst hergestellt werden. Es können auch mehrere Wafer eingesetzt werden, die dann zerteilt werden und mehrere Chips bilden können. Ein Halbleiterbauteil kann auch beispielsweise eine Leiterplatte, mehrere Prozessoren, Halbleiterspeicher, Mikrocontroller, Wandler, Mikrochips etc. umfassen oder selbst sein.

Insbesondere umfasst ein Halbleiterbauteil auch Bauteile, die im Zusammenhang mit der 3D-Integration auftreten. Die 3D-Integration bezeichnet bevorzugt eine integrierte Schaltung, bei der die aktiven elektronischen Komponenten sowohl horizontal also auch vertikal in zwei oder mehr Schichten integriert sind, das heißt, zu einem einzigen Schaltkreis verbunden, einem sogenannten dreidimensional-integrierten Schaltkreis (3D-IC).

Ein Wafer kann beispielsweise eine kreisrunde oder quadratische Scheibe bezeichnen, die einer Dicke im Millimeter oder Submillimeter-Bereich aufweist. Wafer werden typischerweise aus ein- oder polykristallinen (Halbleiter-)Rohlingen, sogenannten Ingots, hergestellt und dienen in der Regel als Substrat für z. B. Beschichtungen oder Bauteile, insbesondere MEMS-Bauteile und/oder elektronische Schaltungen. Die Verwendung des Begriffs Substrat für den Wafer ist im Stand der Technik auch bekannt, wobei das Substrat vorzugsweise das zu behandelnde Material bezeichnet. Im Sinne der Erfindung können die Begriffe Wafer und Substrat synonym verwendet werden.

Der Wafer kann Materialien ausgewählt aus der Gruppe bestehend aus monokristallinem Silizium, Polysilizium, Siliziumdioxid, Siliziumcarbid, Siliziumgermanium, Siliziumnitrid, Nitrid, Germanium, Kohlenstoff, Galliumarsenid, Galliumnitrid, Indiumphosphid und/oder Glas umfassen.

Diese Materialien sind in der Halbleiter- und/oder Mikrosystemtechnik besonders einfach und kostengünstig zu bearbeiten und eignen sich ebenfalls gut für eine Massenherstellung. Ebenso sind diese Materialien für ein Dotieren und/oder ein Beschichten besonders geeignet, um in bestimmten Bereichen die gewünschten elektrischen, thermischen und/oder optischen Eigenschaften zu erzielen. Die vorgenannten Materialien bieten vielfältige Vorteile aufgrund der Verwendbarkeit standardisierter Herstellungstechniken, welche für die Integration von weiteren Komponenten, wie z. B. elektronischen Schaltungen, ebenfalls besonders geeignet sind.

Vertikale Gräben sind vorzugsweise vertikale Vertiefungen im Wafer, die den Durchkontaktierungsbereich umschließen. Die vertikalen Gräben werden ausgehend von einer Oberflächenseite des Wafers gebildet. Nach ihrer Bildung sind sie zu der entsprechenden Oberflächenseite geöffnet, sodass die vertikalen Gräben Seitenwände und/oder einen Boden umfassen. Daraufhin werden sie mit einem Dielektrikum partiell befüllt, wobei sie vorzugsweise mit dem Dielektrikum ausgekleidet werden. Das Auskleiden der vertikalen Gräben umfasst das Beschichten der Seitenwände und/oder des Bodens der vertikalen Gräben mit dem Dielektrikum. Dies kann durch bestimmte Beschichtungsprozesse erfolgen, die in der Mikrosystemtechnik bekannt und geläufig sind, wie beispielsweise die thermische Oxidation von Silizium.

Durch die partielle Befüllung über die Auskleidung der vertikalen Gräben mit dem Dielektrikum wird der Durchkontaktierungsbereich elektrisch isoliert. Es hat sich als besonders vorteilhaft erwiesen, dass durch das Auskleiden und der partiellen Befüllung der vertikalen Gräben mit einem Dielektrikum besonders niedrige parasitäre Kapazitäten auftreten. Zudem werden bevorzugt die vertikalen Gräben durch das Dielektrikum verschlossen, sodass diese hermetisch abgeriegelt sind. Vorteilhafterweise werden dadurch geringste Kontaminationen der vertikalen Gräben durch ein Fluid, wie beispielsweise Luft und/oder Wasser, die die Funktion des Halbleiterbauteils beeinträchtigen könnten, verhindert. Bevorzugt erfolgt das Verschließen der vertikalen Gräben, indem die Öffnung der vertikalen Gräben verschlossen werden. Hierbei kann es bevorzugt sein, dass die Oberfläche Wafer planar mit dem Dielektrikum beschichtet wird, um die vertikalen Gräben zu verschließen und damit hermetisch abzuriegeln. Es kann auch bevorzugt sein, dass lediglich die Öffnungen der vertikalen Gräben durch das Dielektrikum verschlossen werden, um diese hermetisch abzuriegeln.

Ein Durchkontaktierungsbereich bezeichnet im Sinne der Erfindung bevorzugt eine vertikale elektrische Verbindung, um Strom zwischen verschiedenen Leiterbahnebenen zu leiten. Je nach Verwendungszweck kann der Durchmesser und gegebenenfalls die Form des Durchkontaktierungsbereiches unterschiedlich sein. Mit Hilfe des Durchkontaktierungsbereiches ist es vorteilhafterweise möglich, die Leiterbahnebenen zwischen zwei- oder mehrlagigen Wafern zu wechseln.

Im Falle eines Silizium-Wafers ist es üblich, die Silizium-Durchkontaktierung (engl. through silicon via, TSV) in verschiedene Klassen einzuteilen. Via-first TSVs werden vor den aktiven Bauelementen (Transistoren usw., auch als Front-End of Line, FEOL, bezeichnet) prozessiert. Via-middle TSVs strukturiert man nach den aktiven Bauelementen, aber vor deren Verdrahtung (Metallisierung, auch als Back-End of Line, BEOL, bezeichnet). Via-last TSVs werden schließlich nach (oder während) des Aufbringens der Verdrahtungsmetallisierung, also dem BEOL, implementiert.

Der Anschluss des Durchkontaktierungsbereiches mit einer elektrischen Verbindung umfasst bevorzugt die Verbindung des Durchkontaktierungsbereiches mit einer Leiterbahn, um einen elektrischen Kontakt zum Durchkontaktierungsbereich herzustellen.

Leiterbahnen (auch Leitbahn oder Leitungsbahn genannt) bezeichnen elektrisch leitende Verbindungen mit zweidimensionalem Verlauf, das heißt entlang einer Ebene, der sogenannten Leiterbahn- oder Metallisierungsebene. Sie werden bevorzugt zur Verbindung von elektronischen Bauelementen auf Leiterplatten und integrierten Schaltkreisen eingesetzt, das heißt, sie dienen zur Strom- bzw. Spannungsversorgung und/oder zur Signalübertragung. Die Verbindung zwischen einzelnen Leiterbahnebenen erfolgt vorzugsweise mithilfe des Durchkontaktierungsbereiches. Damit keine Kurzschlüsse oder hohen Verlustströme auftreten, müssen die Leiterbahnen elektrisch gut voneinander isoliert sein. Aufgrund des Schichtaufbaus einer Verdrahtung mit mehreren Ebenen können hierbei zusätzliche Dielektrika zum Einsatz kommen. Solche Dielektrika werden hinsichtlich ihrer Funktion in zwei Klassen aufgeteilt: ein Dielektrikum zwischen den Leiterbahnen in einer Ebene (inter-metal dielectric, IMD) und ein Dielektrikum zwischen zwei Leiterbahnebenen (inter-level dieletric, ILD).

In einer weiteren bevorzugten Ausführungsform ist das Verfahren dadurch gekennzeichnet, dass das Halbleiterbauteil ein MEMS-Bauteil und/oder eine elektronische Schaltung umfasst, die durch den Anschluss des Durchkontaktierungsbereiches mit einer elektrischen Verbindung betrieben werden.

Im Sinne der Erfindung bezeichnet ein MEMS-Bauteil bevorzugt ein Bauteil oder eine Komponente, welches auf MEMS-Technologie beruht. MEMS steht für den englischen (im Text mit engl. abgekürzt) Ausdruck *microelectromechanical system,* also ein Mikrosystem, wodurch eine kompakte Bauweise (im Mikrometerbereich) bei gleichzeitig hervorragender Funktionalität mit immer geringeren Herstellungskosten erreicht wird. Ein MEMS-Bauteil kann beispielsweise ein MEMS-Sensor oder auch ein MEMS-Aktuator sein. Im Stand der Technik sind viele MEMS-Bauteile bekannt. Vorteilhafterweise können durch das erfindungsgemäße Verfahren verschiedenste MEMS-Bauteile durch eine Verbindung mit dem Durchkontaktierungsbereich betrieben werden.

Bevorzugte elektronische Schaltungen umfassen ohne Beschränkung eine integrierte Schaltung (IC), eine anwendungsspezifische integrierte Schaltung (ASIC), eine programmierbare logische Schaltung (PLD), ein Field Programmable Gate Array (FPGA), einen Mikroprozessor, einen Mikrocomputer, eine speicherprogrammierbare Steuerung und/oder eine sonstige elektronische, bevorzugt programmierbare, Schaltung.

Vorzugsweise befindet sich das MEMS-Bauteil und/oder die elektronische Schaltung innerhalb einer Kavität des Wafers. Es kann auch bevorzugt sein, dass beispielsweise zwei oder mehr Wafer zu einem Waferstack gebildet werden, die eine Kavität umfassen, worin sich das MEMS-Bauteil und/oder die elektronische Schaltung befinden. Auch der Waferstack kann vorhin genannte Materialien für die Wafer umfassen.

Im Sinne der Erfindung bezeichnet eine Kavität vorzugsweise eine Vertiefung in einen Wafer. Vorteilhafterweise kann durch das Vorhandensein einer oder mehrerer Kavitäten in einem Wafer bzw. Waferstack ein geeigneter Hohlraum für das MEMS-Bauteil und/oder die elektronische Schaltung bereitgestellt werden.

Durch die Verbindung zwischen Durchkontaktierungsbereich, MEMS-Bauteil und/oder elektronischer Schaltung und einer Leiterbahnebene kann Strom zwischen einer Leiterbahnebene über den Durchkontaktierungsbereich zum MEMS-Bauteil und/oder zur elektronischen Schaltung für den Betrieb geleitet werden. Insbesondere kann dies erfolgen, wenn das MEMS-Bauteil in der Kavität verkapselt und besonders beschützt werden muss.

In einer weiteren bevorzugten Ausführungsform ist das Verfahren dadurch gekennzeichnet, dass der Durchkontaktierungsbereich teilweise und/oder durchgängig durch den Wafer verläuft. Dabei kann der Durchkontaktierungsbereich durch den gesamten Wafer (through hole), bis zu einer mittleren Lage des Wafers (blind via) und/oder vergraben zwischen zwei Mittellagen verlaufen (buried via). Vorteilhafterweise können das MEMS-Bauteil und/oder die elektronische Schaltung sich damit in verschiedenen Positionen innerhalb des Wafers oder auf einer Oberfläche des Wafers oder Waferstacks befinden und durch den Anschluss mit dem Durchkontaktierungsbereich betrieben werden.

Jedes elektrische Bauelement zeigt mehr oder weniger stark eine kapazitive Kopplung mit der Umgebung oder parallel zu seinem gewünschten Verhalten. Dieses kapazitive Verhalten kann vor allem bei hohen Frequenzen unerwünschte Auswirkungen haben. Erfindungsgemäß wird das Problem insbesondere dadurch gelöst, dass die vertikalen Gräben, die den Durchkontaktierungsbereich umschließen, partiell mit einem Dielektrikum befüllt und ausgekleidet werden, um vorteilhafterweise das Auftreten von parasitären Kapazitäten zu minimieren.

In einer weiteren bevorzugten Ausführungsform ist das Verfahren dadurch gekennzeichnet, dass der Wafer eine Vorder- und Rückseite aufweist, wobei die Durchkontaktierung von der Vorder- zur Rückseite geführt wird, wobei sich besonders bevorzugt rückseitig ein MEMS-Bauteil und/oder eine elektronische Schaltung befindet, welche durch Anschluss mit dem Durchkontaktierungsbereich kontaktiert werden. Durch die Kontaktierung ergibt sich ein Betrieb des MEMS-Bauteils und/oder der elektronischen Schaltung. In dieser bevorzugten Ausführungsform verläuft der Durchkontaktierungsbereich durch den gesamten Wafer (through hole).

In einer weiteren bevorzugten Ausführungsform ist das Verfahren dadurch gekennzeichnet, dass das Halbleiterbauelement eine Kavität aufweist, in der ein MEMS-Bauteil und/oder eine elektronische Schaltung vorliegt, wobei sich die Kavität bevorzugt innerhalb eines von mindestens zwei Wafer gebildeten Waferstacks befindet und der Durchkontaktierungsbereich durch mindestens einen der beiden Wafer verläuft, wobei sich innerhalb der Kavität ein Unterdruck, vorzugsweise ein Vakuum, befindet.

Ein Waferstack wird aus mindestens zwei Wafers gebildet, kann aber auch 3, 4, 5, 6, 7, 10, 15, 20 oder mehr Wafer umfassen. Die Wafer können dabei sowohl horizontal als auch vertikal in zwei oder mehr Schichten miteinander verbunden werden, sodass sich eine dreidimensionale Ausgestaltung bildet. Vertikale elektrische Verbindungen zwischen verschiedenen Wafern werden dabei durch Durchkontaktierungen ermöglicht. Auch ist es bevorzugt, dass sich zwischen den Wafern eines Waferstacks weitere Schichten, wie beispielsweise eine oder mehrere Oxidschichten, befinden.

Auch der Einsatz oder die Bildung eines oder mehrerer SOI-Wafer kann bevorzugt sein. Ein SOI-Wafer ist ein Waferstack, der zwei Wafer aus Silizium umfasst, wobei sich zwischen den beiden Wafern eine Oxidschicht befindet. Mithilfe von SOI-Wafern werden vorteilhafterweise kürzere Schaltzeiten und geringere Leistungsaufnahmen, besonders bezüglich Leckströmen, ermöglicht.

Das MEMS-Bauteil und/oder die elektronische Schaltung kann innerhalb einer Kavität des Waferstacks auf einen, zwei oder mehr Wafern aufgebaut sein, die ausgerichtet und für die Verbindung untereinander gebondet werden. Es kann auch bevorzugt sein, dass einzelne Wafer beispielsweise über bekannte Polierverfahren aus der Mikrosystemtechnik abgedünnt werden. Die Abdünnung der Wafer kann vor oder nach dem Bonden durchgeführt werden. Vertikale elektrische Verbindung (Durchkontaktierungen) können ebenfalls entweder vor dem Bonden eingebracht oder nach der Herstellung des Stapels hergestellt werden.

Das Bonden von Wafern beschreibt bevorzugt einen Verfahrensschritt in der Halbleiter- und Mikrosystemtechnik, bei dem zwei Wafer oder Scheiben, z. B aus Silizium, Quarz, Glas und/oder den vorgenannten bevorzugten Materialien miteinander verbunden werden.

Beim Bonden können vorzugsweise verschiedene Verfahren zum Einsatz kommen. Diese werden auch als Bondprozesse oder Bondverfahren bezeichnet. Bevorzugte Bondprozesse umfassen direktes Bonden, anodisches Bonden, Bondverfahren mit Zwischenschichten, Glas-Frit-Bonden, adhäsives Bonden und/oder selektives Bonden.

Beim direkten Bonden, insbesondere von Silizium-Wafern, werden bevorzugt hydrophile und hydrophobe Oberflächen der Wafer unter hohen Temperaturen in Kontakt gebracht. Vorzugsweise wird dabei der eine Wafer mittig gegen den anderen gepresst, wobei vorteilhafterweise ein erster Kontaktpunkt entsteht. Diese mechanische Verbindung im Kontaktbereich beruht dabei vorzugsweise auf Wasserstoffbrücken und/oder Van-der-Waals-Wechselwirkungen. Der somit verbundene Kontaktbereich wird dabei vorzugsweise auf die übrige Waferfläche(n) ausgedehnt, indem anfangs vorhandene Abstandhalter zwischen diesen Flächen sukzessive entfernt werden. Dabei betragen die Prozesstemperaturen vorzugsweise zwischen 1000 °C und 1200 °C und es wird ein Druck auf die Wafer von beispielsweise der Größenordnung 10 Megapascal (MPa) bis 25 MPa ausgeübt. Das Direkt-Bonden kann vorzugsweise für die Verbindung zweier Silizium-Wafer und/oder Siliziumdioxid-Wafer verwendet werden.

Beim anodischen Bonden findet insbesondere ein Glas mit erhöhter Na+-Ionenkonzentration (bevorzugt positiv geladenen Natriumionen) Verwendung, welches bevorzugt mit einem Silizium-Wafer in Kontakt gebracht wird. Dabei wird eine elektrische Spannung angelegt, welche insbesondere konfiguriert ist, eine negative Polung am Glas zu erzeugen. Somit wird bevorzugt und insbesondere mithilfe einer erhöhten Prozesstemperatur erreicht, dass die Natriumionen (Na+) zur Elektrode diffundieren, wodurch sich bevorzugt eine Raumladungszone an der Grenzfläche ausbildet, welches eine Erhöhung des elektrischen Feldes bewirkt und Si-O-Si-Bindungen erzeugt. Diese Bindungen weiten sich bevorzugt sukzessive auf die gesamte Verbindungsfläche zwischen Glas und Silizium aus. Somit können insbesondere Glas und Silizium-Wafer miteinander verbunden werden. Bei entsprechender Anpassung des Prozesses ist ebenso ein Bonden zweier Siliziumlagen und/oder einer Silizium-Metall Lage mit einem Glas möglich. Das anodische Bonden kann vorzugsweise bei Temperaturen von etwa 400 °C stattfinden, es kann ebenso bevorzugt bei "Niedrigtemperatur" bei etwa 180 °C stattfinden, wobei die zu bondenden Materialien vorzugsweise geschont werden. Bevorzugt können auch verschiedene der vorgenannten Materialien gebonded werden.

Bevorzugt können auch Bond-Verfahren mit sogenannten Zwischenschichten zwischen den zu bondenden Wafern zum Einsatz kommen, wie bspw. das sogenannte Eutektische Bonden, welches vorzugsweise auf der Verbindung durch eine eutektische Legierung als Zwischenschicht, z. B. Si-Au (Silizium-Gold) oder Ge-Al (Germanium-Aluminium), basiert. Eine eutektische Legierung ist vorzugsweise eine Legierung, deren Bestandteile in einem solchen Verhältnis zueinander gemischt sind, dass bei einer bestimmten Temperatur die ganze Legierung flüssig bzw. fest wird. Eutektisches Bonden kann z. B. zum Verbinden zweier Silizium-Wafer verwendet werden. Bevorzugt können jedoch auch andere der vorgenannten Materialien verbunden werden.

Auch das Glas-Frit-Bonden beruht bevorzugt auf der Verwendung einer Zwischenschicht zwischen den zu verbindenden Wafern, wobei die Verbindungsbildung insbesondere durch Aufschmelzen von Glasloten/Glas-Fritten. Glaslot umfasst bevorzugt ein Glas, welches eine niedrige Erweichungstemperatur aufweist, bspw. ca. 400 °C. Glas-Fritten umfasst bevorzugt oberflächlich geschmolzenes Glaspulver, dessen Glaskörner bevorzugt zumindest teilweise zusammenbacken bzw. -sintern. Diese Art des Bondens kann bevorzugt Silizium- und/oder Siliziumdioxidwafer miteinander verbinden, bevorzugt jedoch auch andere vorgenannte Materialien.

Das adhäsive Bonden beschreibt bevorzugt eine Verbindungsbildung durch eine Zwischenschicht umfassend Klebstoff. Durch adhäsives Bonden können vorzugsweise verschiedene der vorgenannten Materialien miteinander gebonded werden.

Bevorzugt kann durch Fotolithographie, Ätzen und/oder Lift-off-Verfahren ein selektives Bonden vorgenommen werden.

Durch das Bonden von Wafern, welche bevorzugt für das Bereitstellen einer Kavität für das MEMS-Bauteil und/oder für die elektronische Schaltung vorbearbeitet worden sind, lässt sich besonders einfach ein Halbleiterbauteil herstellen.

Das Bonden von Strukturen aus vorbearbeiteten Wafern erlaubt die einfache Herstellung komplexer Strukturen, welche nur mit großem Aufwand aus einem einzelnen Wafer hergestellt werden könnten. Dadurch kann das Halbleiterbauteil hergestellt werden, ohne dass das Rohmaterial aufwendig aus dem Inneren herausgearbeitet werden muss, um eine Kavität innerhalb des Halbleiterbauteils zu erzeugen.

Vorzugsweise liegt innerhalb der Kavität, in der sich das MEMS-Bauteil und/oder die elektronische Schaltung befindet, ein Unterdruck. Dies ist dahingehend von Vorteil, dass die Wafer des Waferstacks besonders fest zusammengehalten werden, insbesondere im Bereich der Kavität, sodass das MEMS-Bauteil und/oder die elektronische Schaltung ausgesprochen gut vor der Umgebung des Halbleiterbauteils geschützt sind. Daher ist es besonders bevorzugt, dass sich innerhalb dieser Kavität ein Vakuum befindet.

Der durchschnittliche Fachmann weiß, dass in der Realität ein Vakuum niemals absolut ist, sondern sich durch einen erheblich geringeren Druck gegenüber dem Atmosphärendruck bei Normalbedingungen auszeichnet. Ein Unterdruck bezeichnet einen relativen Druck, der unter dem Umgebungsdruck liegt.

In einer weiteren bevorzugten Ausführungsform ist das Verfahren dadurch gekennzeichnet, dass die vertikalen Gräben mit einem porösen Low-k-Dielektrikum befüllt werden, bevorzugt ausgewählt aus einer Gruppe poröser organischer Materialien, poröses Kohlenstoff-dotiertes Siliziumoxid, Silikagel, Silicatische Aerogele, mesoporöses Siliziumnitrid, Polysilizium und/oder TEOS (Tetraethylorthosilicat), poröses Wasserstoff-Silsesquioxan, mesoporöse Silikatgläser, Phosphorpartikel und/oder Aluminiumoxidpartikel.

Als Low-k-Dielektrikum wird in der Halbleitertechnologie ein Material bezeichnet, das eine im Wesentlichen niedrigere relative Permittivität als Siliziumdioxid ($SiO_2$) aufweist, d. h. $\varepsilon_r < 3{,}9$.

Der Einsatz von Low-k-Dielektrika hat sich als besonders vorteilhaft erwiesen, da hierdurch auftretende parasitäre Kapazitäten erheblich reduziert werden.

Begriffe wie im Wesentlichen, ungefähr, etwa, ca. etc. beschreiben bevorzugt einen Toleranzbereich von weniger als $\pm$ 40 %, bevorzugt weniger als $\pm$ 20 %, besonders bevorzugt weniger als $\pm$ 10 %, noch stärker bevorzugt weniger als $\pm$ 5 % und insbesondere weniger als $\pm$ 1% und umfassen stets den exakten Wert. Ähnlich beschreibt bevorzugt Größen, die ungefähr gleich sind. Teilweise beschreibt bevorzugt zu mindestens 5 %, besonders bevorzugt zu mindestens 10 %, und insbesondere zu mindestens 20 %, in einigen Fällen zu mindestens 40 %.

Um die Eigenschaften von Halbleiterbauteilen zu verbessern, die MEMS-Bauteile und/oder elektronische Schaltungen, wie beispielsweise integrierte Schaltungen, umfassen, den Stromverbrauch der hochintegrierten Schaltkreise zu verringern oder höhere Schaltgeschwindigkeiten zu erzielen, werden die Strukturen verkleinert. Durch die immer fortschreitende Miniaturisierung mikroelektronischer Bauteile gewinnen physikalische Effekte an Bedeutung, die in dem Größenbereich einen Funktionsbetrieb der Halbleiterbauteile stören können. Ein Effekt der Miniaturisierung ist die Abstandsverringerung der Leiterbahnebenen für die Kontaktierung. Durch diese Verkleinerung der Isolatordicke zwischen zwei Leiterbahnen steigt der Einfluss der parasitären Kapazitäten. Sie stören die Funktion beispielsweise von Schaltkreisen und verringern dabei die maximale Schaltgeschwindigkeit.

Wie eingangs erläutert, ist die relative Permittivität eine relevante Größe bei der Betrachtung parasitärer Kapazitäten. Gleichung (1) macht deutlich, dass die Verringerung des Abstandes d die Kapazität C erhöht. Um dies auszugleichen, ist es notwendig, die "Plattenfläche" A, was im Wesentlichen dem Leiterbahnquerschnitt entspricht, oder die relative Permittivität $\varepsilon_r$ zu verringern. Der Leiterbahnquerschnitt und somit die Plattenfläche der parasitären Kapazitäten werden aber kaum verkleinert, da der Strom, insbesondere die Stromdichte, in den Leiterbahnen nicht steigen darf und kleinere Querschnitte den elektrischen Widerstand durch stärkeren Einfluss der Grenzflächenstreuung der Elektronen erhöhen. Low-k-Dielektrika stellen eine neue Entwicklung für isolierende Schichten mit niedriger relativer Permittivität dar.

Eine Möglichkeit, um die relative Permittivität zu verringern bzw. möglichst gering zu halten, ist es, die Polarisierbarkeit durch die Verwendung von Materialien mit wenig polaren Bindungen zu senken. Bekannte Beispiele für solche Bindungen sind Kohlenstoff-Kohlenstoff- (C-C), Kohlenstoff-Wasserstoff- (C-H), Silizium-Fluor- (Si-F) und/oder Silizium-Kohlenstoff-Bindungen (Si-C). Die oben erwähnten Materialien weisen unter anderem diese Bindungen auf, sodass vorteilhafterweise die relative Permittivität verringert wird, um den Wert der parasitären Kapazitäten möglichst gering zu halten.

Eine weitere Möglichkeit, um die relative Permittivität und damit die parasitären Kapazitäten zu verringern, ist es, die Materialdichte bzw. insbesondere die Dipoldichte, durch die Bildung von freiem Volumen zu verringern. Erfindungsgemäß wird dies dadurch erlangt, dass die vertikalen Gräben partiell befüllt werden und sie mit einem Dielektrikum, vorzugsweise mit einem Low-k-Dielektrikum, lediglich ausgekleidet werden. Eine vollständige Befüllung der vertikalen Gräben erfolgt vorzugsweise nicht.

Eine weitere Möglichkeit, um freies Volumen zur Senkung der Dipoldichte zu schaffen, liefern poröse Dielektrika, insbesondere poröse Low-k-Dielektrika, zur partiellen Befüllung der vertikalen Gräben. Hierbei kann die partielle Befüllung auch eine nahezu vollständige Befüllung mit porösen Low-k-Dielektrika betreffen, wobei aufgrund der vorhandenen Poren ein freies (nicht vollständig mit einem Material) befülltes Volumen bleibt.

Mit dem zusätzlichen freien Volumen, der dadurch gebildet wird, dass vertikalen Gräben ausgekleidet werden und dabei insbesondere ein Leerraum freibleibt, in Kombination mit der porösen Struktur des Low-k-Dielektrikums, ergibt sich eine besonders reduzierte relative Permittivität, sodass vorteilhafterweise parasitäre Kapazitäten beträchtlich verringert werden.

Porös bezeichnet hierbei bevorzugt, dass das Material durchlässig ist und/oder insbesondere mit Poren, also feinen Löchern, versehen ist. Verschiedene Porengrößen können bevorzugt zum Einsatz kommen, beispielsweise Mikroporen (Porengröße kleiner als 2 nm), Mesoporen (Porengröße zwischen 2 und 50 nm) und/oder Makroporen (Porengröße größer als 50 nm).

In einer weiteren bevorzugten Ausführungsform ist das Verfahren dadurch gekennzeichnet, dass sich innerhalb der vertikalen Gräben nach dem Verschließen ein Unterdruck, vorzugsweise ein Vakuum, befindet.

Vorteilhaft führt ein Unterdruck innerhalb der vertikalen Gräben zu einem besonders dichten und hermetischen Verschluss, was eine hohe Zuverlässigkeit und optimale Funktionstüchtigkeit begünstigt.

In einer weiteren bevorzugten Ausführungsform ist das Verfahren dadurch gekennzeichnet, dass vor dem Verschließen die vertikalen Gräben mit einem Gas befüllt werden, welches vorzugsweise eine niedrigere Dielektrizitätszahl aufweist als das Dielektrikum zum Verschließen.

Vorteilhafterweise wird durch das zusätzliche dielektrische Gas die relative Permittivität nochmals deutlich verringert und damit auch auftretende parasitäre Kapazitäten. Vorzugsweise ist das dielektrische Gas nicht brennbar, um mögliche Gefahren während der Einfuhr in die vertikalen Gräben zu verringern. Es ist auch bevorzugt, dass das Gas chemisch untätig gegenüber dem verwendeten Wafermaterial und/oder dem Dielektrikum ist, womit die vertikalen Gräben ausgekleidet werden, um mögliche Beschädigungen zu vermeiden. Insbesondere sind umweltfreundliche und/oder nicht-giftige dielektrische Gase bevorzugt.

Ein dielektrisches Gas kann auch als Isoliergas bezeichnet werden. Ein dielektrisches Gas ist vorzugsweise ein dielektrisches Material im gasförmigen Zustand, welches eine elektrische Entladung verhindern und/oder zur Isolierung dienen kann. Luft, Schwefelhexafluorid ($SF_6$), Ammoniak ($NH_3$), Kohlendioxid, Kohlenmonoxid, Stickstoff und Wasserstoff sind Beispiele für gasförmige dielektrische Materialien.

Es hat sich als bevorzugt herausgestellt, dass die vertikalen Gräben im Wesentlichen ein Aspektverhältnis bis zu 50:1 und/oder im Wesentlichen eine Tiefe zwischen 100 $\mu$m und 1000 $\mu$m aufweisen. Das Aspektverhältnis von Höhe zu Breite kann insbesondere von 15:1 bis 50:1 reichen. In weiteren Ausführungsformen kann die Tiefe von 1 $\mu$m bis einem oder mehreren Millimetern reichen. Ein Beispiel bildet ein Aspektverhältnis von ca. 30:1 mit der Tiefe zwischen 10 $\mu$m und 200 $\mu$m. Die genannten Aspektverhältnisse haben sich dahingehend als vorteilhaft herausgestellt, dass die mechanischen Spannungen innerhalb des Wafers, des Waferstacks und/oder des Halbleiterbauteils selbst zu einem Verzug nahe Null führen.

Die genannten Aspektverhältnisse sind auch dahingehend relevant, dass ein Innenraum der vertikalen Gräben, also insbesondere die Seitenwände und der Boden, sich besonders einfach durch die im Stand der Technik bekannten und zuverlässigen Beschichtungsverfahren mit einem Dielektrikum auskleiden und damit partiell befüllen lassen. Insbesondere in Bezug auf die laterale Ausbreitung der Öffnung der vertikalen Gräben sind die genannten Aspektverhältnisse dahingehend vorteilhaft, dass sie sich durch eine konforme Abscheidung eines Dielektrikums sehr einfach und besonders gut verschließen lassen. Damit werden die vertikalen Gräben hermetisch abgeriegelt, sodass ein Stoffaustausch mit der Umgebung des Wafers, des Waferstacks und/oder des Halbleiterbauteils verhindert wird.

Als Aspektverhältnis (engl. aspect ratio) bezeichnet man das Verhältnis aus der Tiefe bzw. Höhe zu ihrer (kleinsten) lateralen Ausdehnung. Wird beispielsweise durch ein Ätzverfahren in einem Silizium-Wafer ein 40 $\mu$m breiter, beliebig langer und 100 $\mu$m tiefer Graben erzeugt, so hat dieser Graben das Aspektverhältnis 2,5:1. Solche Aspektverhältnisse größer als 1 erfordern den Einsatz von anisotropen Strukturierungsmethoden, beispielsweise das reaktive Ionenätzen (RIE). Bei monokristallinen Wafern, wie beispielsweise Silizium-Wafern, können durch anisotropes Ätzen, beispielsweise mit Kalilauge, auch nasschemisch Strukturen mit hohem Aspektverhältnis erzeugt werden.

In einer weiteren bevorzugten Ausführungsform ist das Verfahren dadurch gekennzeichnet, dass die vertikalen Gräben einen Mund aufweisen und ausgehend von einer Breite des Mundes lateral zu einem Bauch aufgeweitet sind.

Der Mund bezeichnet vorzugsweise einen ersten Abschnitt der vertikalen Gräben, der ausgehend von einer Oberflächenseite gebildet wird. Der Bauch bezeichnet bevorzugt einen tieferliegenden zweiten Abschnitt, der gegenüber dem Mund lateral aufgeweitet ist.

Durch die laterale Aufweitung zu einem Bauch erhöht sich insbesondere die Breite der vertikalen Gräben und somit auch der Abstand des Durchkontaktierungsbereiches zu anderen Bereichen des Wafers und/oder des Halbleiterbauteils, beispielsweise zu anderen Durchkontaktierungsbereichen. Gemäß Gleichung (1) folgt hierdurch auch, dass vorteilhafterweise durch die laterale Aufweitung zu einem Bauch die parasitären Kapazitäten nochmals reduziert werden. Zudem folgt durch die laterale Aufweitung zum Bauch, dass die laterale Dimension des Durchkontaktierungsbereiches selbst geringgehalten wird, was vorteilhaft ist, um eine möglichst niedrige Dimension des Halbleiterbauteils und auch einen möglichst geringen Innenwiderstand des Durchkontaktierungsbereiches zu gewährleisten.

Es ist bevorzugt, dass die vertikalen Gräben im Bereich des Bauches um mindestens 2 $\mu$m, vorzugsweise um mindestens 5 $\mu$m oder auch um mindestens 10 $\mu$m im Vergleich zur Breite eines Mundes zusätzlich lateral aufgeweitet sind, wobei es bevorzugt ist, dass die laterale Aufweitung weniger als 20 $\mu$m, bevorzugt weni-

ger als 10 μm beträgt.

Des Weiteren ist es bevorzugt, dass der Mund eine Tiefe von weniger als 5 μm und eine Breite von weniger als 2 μm aufweist und/oder der Bauch eine Breite von mindestens 10 μm, vorzugsweise mindestens 20 μm aufweist.

Umso niedriger die Tiefe des Mundes ist, desto weiter kann der Bauch des vertikalen Grabens aufgeweitet werden und damit die parasitäre Kapazität weiter verringert werden. Auch die Breite des Mundes kann eine prozessrelevante Größe darstellen, da mit einer möglichst geringen Breite des Mundes sich dieser vorteilhafterweise besonders einfach mit einem Dielektrikum verschließen lässt. Insbesondere ist es bei einer niedrigen Breite des Mundes vorteilhafterweise ausreichend, eine möglichst dünne dielektrische Schicht abzuscheiden, um den vertikalen Graben zu verschließen.

In einer weiteren bevorzugten Ausführungsform ist das Verfahren dadurch gekennzeichnet, dass die vertikalen Gräben, insbesondere der Mund und/oder der Bauch, durch nasschemische Ätzverfahren und/oder Trockenätzverfahren, bevorzugt physikalische und/oder chemische Trockenätzverfahren, besonders bevorzugt durch reaktives Ionenätzen und/oder reaktives Ionentiefenätzen (Bosch-Prozess), oder durch eine Kombination der vorgenannten Ätzverfahren gebildet werden.

Ein Ätzverfahren bezeichnet bevorzugt die Abtragung von Material einer Oberfläche. Synonym kann hierfür auch der Begriff des Ätzprozesses verwendet werden. Die Abtragung kann sich in Form von Vertiefungen veräußern, die Kavitäten an Wafern hinterlassen.

Unter Trockenätzen fasst man in der Halbleitertechnologie und in der Mikrosystemtechnik eine Gruppe von abtragenden Mikrostrukturverfahren zusammen, die nicht auf nasschemischen Reaktionen (wie nasschemisches Ätzen, chemisch-mechanisches Polieren) basieren. Der Materialabtrag erfolgt dabei entweder durch beschleunigte Teilchen oder mithilfe plasmaaktivierter Gase. Es werden also je nach Verfahren chemische sowie physikalische Effekte ausgenutzt.

Trockenätzverfahren lassen sich in drei Gruppen einordnen. Zum einen die physikalischen Trockenätzverfahren, sie basieren auf dem Materialabtrag durch Beschuss mit Teilchen, zum anderen chemische Trockenätzverfahren, sie basieren auf einer chemischen Reaktion eines meist plasmaaktiverten Gases. Die dritte Gruppe, die physikalisch-chemischen Trockenätzverfahren, fasst Prozesse zusammen, die beide Wirkmechanismen nutzen, und ist so in der Lage, die Nachteile der ersten beiden Gruppen zu minimieren.

Beim nasschemischen Ätzen wird eine ätzresistente Maskierung durch einen chemischen Abtragungsprozess in den Wafer übertragen.

Plasmaätzen ist ein materialabtragendes, plasmaunterstütztes Trockenätzverfahren. Beim Plasmaätzen unterscheidet man zwischen einem Ätzabtrag aufgrund einer chemischen Reaktion und einem physikalischen Abtrag der Oberfläche aufgrund von Ionenbeschuss.

Beim chemischen Plasmaätzen erfolgt der Materialabtrag durch eine chemische Reaktion. Deshalb ist es im Allgemeinen isotrop und aufgrund des chemischen Charakters auch sehr materialselektiv. Beim physikalischen Plasmaätzen, auch plasmaunterstütztes Ionenätzen genannt, handelt es sich um ein physikalisches Verfahren. Bei diesem Verfahren kann eine gewisse Vorzugsrichtung im Ätzangriff entstehen, daher weisen die Verfahren unter Umständen eine Anisotropie im Materialabtrag auf. Beim physikalischen Plasmaätzen werden im Plasma nicht reaktive Ionen erzeugt. Durch ein angelegtes elektrisches Feld werden diese Ionen auf eine Oberfläche beschleunigt und entfernen so Teile der Oberfläche. Dieses Verfahren wird typischerweise zum Entfernen des natürlichen Oxides auf Silizium-Wafern verwendet.

Das reaktive Ionenätzen (engl. reactive ion etching, RIE) ist ein ionenunterstützter Reaktivätsprozess. RIE ist wegen der guten Kontrollierbarkeit des Ätzverhaltens ein Verfahren zur Herstellung von topografischen Strukturen für die Mikro- und Nanosystemtechnologie. Das Verfahren lässt durch chemisch-physikalischen Abtrag sowohl eine isotrope (richtungsunabhängig) als auch eine anisotrope Ätzung zu. Das Ätzen erfolgt durch aufgeladene Teilchen (Ionen), die in einem Gasplasma erzeugt wurden. Eine entsprechende Maskierung (z. B. durch Fotolithografie erzeugt) der Oberfläche gibt die Formgebung der Strukturen.

Reaktives Ionentiefenätzen (engl. deep reactive ion etching, DRIE) ist eine Weiterentwicklung des reaktiven Ionenätzens (RIE) und ein hoch anisotroper Trockenätzprozess für die Herstellung von Mikrostrukturen in Wafern mit einem Aspektverhältnis von bis zu 50:1, wobei Strukturtiefen von einigen 100 Mikrometern erreicht werden können. Der DRIE-Prozess ist ein zweistufiger, alternierender Trockenätzprozess, bei dem sich Ätz- und Passivierungsschritte abwechseln. Ziel ist es, möglichst anisotrop zu ätzen, das heißt richtungsabhängig, senkrecht zur WaferOberfläche. Auf diese Weise können beispielsweise sehr schmale Gräben geätzt werden.

Die vorgenannten Ätzprozesse sind dem Fachmann bekannt. In Abhängigkeit der gewünschten Öffnungen in den bereitgestellten Wafer, können vorteilhafte Verfahren gewählt werden, um eine effiziente Durchführung zu gewährleisten.

In einer weiteren bevorzugten Ausführungsform ist das Verfahren dadurch gekennzeichnet, dass die vertikalen Gräben mit einem Dielektrikum verschlossen werden.

Bevorzugt können die vertikalen Gräben mit dem Dielektrikum planar verschlossen werden. Das Verschließen der vertikalen Gräben mit einem Dielektrikum hat sich in verschiedenen Aspekten als vorteilhaft erwiesen. Zum einen erlangen die vertikalen Gräben mit dem Verschluss durch ein Dielektrikum einen besonders guten hermetischen Verschluss, zum anderen ist es - insbesondere im Falle eines planaren Verschlusses besonders einfach, weitere planare Prozesse des Verfahrens während der Herstellung durchzuführen. Ein solcher planarer Prozess kann insbesondere ein Planarisieren von Wafern sein. Dadurch, dass z. B. Leiterbahnen ein gewisses strukturelles Muster auf der Oberfläche des Wafers erzeugen, kommt es zu störenden Unebenheiten (z. B. Störung der Lithografie durch Schrägreflexion, Ungleichmäßigkeiten in folgenden Abscheidungen). Daher wird insbesondere an mehreren Stellen im Fertigungsablauf der Wafer erneut planarisiert. Das kann beispielsweise durch selektives Zurückätzen oder durch chemisch-mechanisches Polieren (CMP) erfolgen. Nicht nur das Polieren hinterlässt Partikel auf der Oberfläche, die für den nächsten Lithografieschritt völlig rein und eben sein muss. Auch z. B. Ätzprozesse hinterlassen Rückstände von unerwünschten Reaktionsprodukten. Im ersten Fall werden die Wafer mechanisch durch Bürsten und Ultraschallbad gereinigt, im zweiten Fall durch nasschemische Verfahren und ebenfalls Ultraschall. Um besonders einfach zusätzliche planare Prozesse auf dem Wafer und/oder auf dem Waferstack durchzuführen, hat es sich als Vorteil erwiesen, dass die vertikalen Gräben planar mit einem Dielektrikum verschlossen werden.

Ein planares Verschließen der vertikalen Gräben bezeichnet insbesondere eine Beschichtung des Wafers mit einem Dielektrikum, wobei sich das Dielektrikum im Wesentlichen entlang der Ebene des Wafers erstreckt, an denen die vertikalen Gräben ausgebildet sind.

In einer weiteren Ausführungsform ist das Verfahren dadurch gekennzeichnet, dass die vertikalen Gräben durch eine Auskleidung mit dem Dielektrikum hermetisch verschlossen werden und/oder zum hermetischen Verschließen zusätzlich eine Siegelschicht aufgebracht wird, wobei das Dielektrikum zum partiellen Befüllen und Auskleiden der vertikalen Gräben und/oder die Siegelschicht Siliziumnitrid, Tetraethylorthosilicat (TEOS), Siliziumoxinitrid und/oder Siliziumdioxid umfasst.

Die genannten Materialien sind besonders einfach und kostengünstig zu bearbeiten und eignen sich hervorragend für eine Massenanfertigung. Diese Materialien sind auch besonders gut für ein Bearbeiten und/oder Beschichten geeignet, um einen optimalen hermetischen Verschluss der vertikalen Gräben zu bilden. Erfindungsgemäß wird bevorzugt für einen besonders guten hermetischen Verschluss eine Siegelschicht angebracht, mit der die vertikalen Gräben partiell befüllt und/oder an die Seitenwände und den Boden zusätzlich zum Dielektrikum angebracht werden. Die genannten Materialien bieten große Vorteile, welche aufgrund der Verwendung von standardisierten Herstellungstechniken für eine Beschichtung und Auskleidung der vertikalen Gräben sehr gut geeignet sind.

Das partielle Befüllen und das Auskleiden der vertikalen Gräben geschieht vorzugsweise über im Stand der Technik bekannte Beschichtungsverfahren.

Vorzugsweise erfolgt die Beschichtung durch ein Beschichtungsverfahren innerhalb der Beschichtungsanlage, bevorzugt durch eine Sprühbeschichtung, Nebelbeschichtung und/oder Dampfbeschichtung.

Eine Sprühbeschichtung bezeichnet insbesondere ein flächiges Aufbringen eines Dielektrikums, wobei das Dielektrikum vor dem Sprühen vorzugsweise unter Druck gestellt wird (z. B. größer als der vorherrschende Umgebungsdruck), sodass feine Partikel/Aerosole des Dielektrikums und/oder ein Schaum entstehen. Dadurch kann eine besonders feine Beschichtung erreicht werden, welche alle besprühten Bereiche bedeckt, auch wenn diese beispielsweise Flächen aufweisen, welche gegenüber der Sprührichtung in einem ungünstigen Winkel liegen. Auch zueinander abgewinkelte Flächen/Bereiche können so bevorzugt direkt bedeckt werden.

Bevorzugt wird hierfür ein flüssiges Dielektrikum unter gegenüber der Umgebung erhöhten Druck zerstäubt und flächig aufgebracht.

Die Sprühbeschichtung ist vorzugsweise eine Sprühbelackung. Die Sprühbeschichtung kann auch eine Gasphasenabscheidung sein.

Eine Nebelbeschichtung umfasst vorzugsweise eine Beschichtung durch feine Tröpfchen des Dielektrikums, welche in einer Atmosphäre (bevorzugt ein Gas) fein verteilt sind. Eine Dampfbeschichtung erfolgt vorzugsweise durch ein aufzutragendes Dielektrikum in Dampfform, bzw. gasförmig.

Vorzugsweise erfolgt die Beschichtung über eine Beschichtungsanlage, die eine physikalische Beschichtungsanlage oder chemische Beschichtungsanlage, bevorzugt plasmagestützte chemische Beschichtungsanlage, Niederdruck-chemische und/oder Epitaxie-Beschichtungsanlage sein kann.

Eine physikalische Beschichtungsanlage bezeichnet bevorzugt eine Beschichtungsanlage, die die Beschichtung durch die physikalische Gasphasenabscheidung durchführt. Die physikalische Gasphasenabscheidung (engl. physical vapour deposition, PVD), selten auch physikalische Dampfphasenabscheidung, bezeichnet eine Gruppe von vakuumbasierten Beschichtungsverfahren bzw. Dünnschichttechnologien. Anders als bei Verfahren der chemischen Gasphasenabscheidung wird mithilfe physikalischer Verfahren das Ausgangsmaterial in die Gasphase überführt. Das gasförmige Material wird anschließend zum zu beschichtenden Wafer geführt, wo es kondensiert und die Zielschicht bildet.

Eine Epitaxie-Beschichtungsanlage bezeichnet bevorzugt eine Anlage, worin ein Epitaxie-Verfahren angewendet wird, bevorzugt die Molekularstrahlepitaxie. Die Molekularstrahlepitaxie (engl. molecular beam epitaxy, MBE) ist ein Verfahren der physikalischen Gasphasenabscheidung (PVD), um kristalline dünne Schichten (bzw. Schichtsysteme) herzustellen. Epitaxie bedeutet, dass die Kristallstruktur der aufwachsenden Schicht sich der des Substrates anpasst, solange die physikalischen Eigenschaften der beiden Substanzen nicht zu stark voneinander abweichen.

Das Sputtern (von engl. to sputter = zerstäuben), auch Kathodenzerstäubung genannt, ist ein physikalischer Vorgang, bei dem Atome aus einem Festkörper (Target) durch Beschuss mit energiereichen Ionen (vorwiegend Edelgasionen) herausgelöst werden und in die Gasphase übergehen.

Auch eine Beschichtung mithilfe einer galvanischen Abscheidung (auch als Galvanotechnik oder Galvanik) kann bevorzugt sein. Die galvanische Abscheidung bezeichnet bevorzugt die elektrochemische Abscheidung materieller Niederschläge, also von Überzügen auf Wafern in einem elektrolytischen Bad..

Eine chemische Beschichtungsanlage bezeichnet bevorzugt eine Beschichtungsanlage, die über die chemische Gasphasenabscheidung Beschichtungen durchführt. Bei der chemischen Gasphasenabscheidung (engl. chemical vapour deposition, CVD) wird an der erhitzten Oberfläche eines Wafers aufgrund einer chemischen Reaktion aus der Gasphase eine Feststoffkomponente abgeschieden. Eine besondere Eigenschaft des Verfahrens ist die konforme Schichtabscheidung, wodurch auch z. B. feinste Vertiefungen in Wafern gleichmäßig beschichtet werden. Umfasst von der chemischen Gasphasenabscheidung ist auch die Atomlagenabscheidung (engl. atomic layer deposition, ALD).

Die plasmagestützte chemische Beschichtungsanlage bezeichnet bevorzugt eine Anlage, die das Verfahren der plasmagestützten oder plasmaunterstützten chemischen Gasphasenabscheidung nutzt (engl. plasma-enhanced chemical vapour deposition, PECVD; auch engl. plasma-assisted chemical vapour deposition, PACVD, genannt). Das Plasma kann direkt beim zu beschichtenden Wafer (Direktplasma-Methode) oder in einer getrennten Kammer (Remote-Plasma-Methode) brennen. Während bei der CVD die Dissoziation der Moleküle des Gases durch externe Zufuhr von Wärme sowie die freigewordene Energie der folgenden chemischen Reaktionen geschieht, übernehmen diese Aufgabe bei der PECVD beschleunigte Elektronen im Plasma. Zusätzlich zu den auf diese Weise gebildeten Radikalen werden in einem Plasma auch Ionen erzeugt, die zusammen mit den Radikalen die Schichtabscheidung auf dem Wafer bewirken. Die Gastemperatur im Plasma erhöht sich dabei in der Regel um wenige Hundert Grad Celsius, wodurch im Gegensatz zur CVD auch temperaturempfindlichere Materialien beschichtet werden können. Bei der Direktplasma-Methode wird zwischen dem zu beschichtenden Wafer und einer Gegenelektrode ein starkes elektrisches Feld angelegt, durch das ein Plasma gezündet wird. Bei der Remote-Plasma-Methode ist das Plasma so angeordnet, dass es keinen direkten Kontakt zum Substrat hat. Dadurch erzielt man Vorteile bzgl. selektiver Anregung von einzelnen Komponenten eines Prozessgasgemisches und verringert die Möglichkeit einer Plasmaschädigung der Waferoberfläche durch die Ionen.

Niederdruck-CVD (engl. low pressure chemical vapour deposition, LPCVD) ist das in der Halbleitertechnologie häufig eingesetzte Verfahren zur Abscheidung von Siliciumoxid, Siliciumnitrid und poly-Silicium, sowie von Metallen.

In einer weiteren bevorzugten Ausführungsform ist das Verfahren dadurch gekennzeichnet, dass zur Bereitstellung eines Anschlusses einer elektrischen Verbindung ein Bereich am Durchkontaktierungsbereich mit einem leitfähigen Material kontaktiert wird, wobei bevorzugt ein Bereich einer Oxidschicht am Durchkontaktierungsbereich strukturiert und/oder ausgelassen wird und in dem Bereich einer Auslassung das leitfähige Material mit dem Durchkontaktierungsbereich kontaktiert wird.

Vorteilhaft kann ein direkter elektrischer Kontakt mit dem Durchkontaktierungsbereich ermöglicht werden. Das leitfähige Material beispielsweise durch eine oder mehrere Metallschichten bereitgestellt werden, um den Stromtransport bereitzustellen.

In einer weiteren Ausführungsform ist das Verfahren dadurch gekennzeichnet, dass zur Bereitstellung eines Anschlusses einer elektrischen Verbindung für das Betreiben des MEMS-Bauteils und/oder der elektronischen Schaltung mit dem Durchkontaktierungsbereich eine Anschlussöffnung gebildet wird, welche mit einem leitfähigen Material gefüllt wird. Die Anschlussöffnung kann in einem oder mehreren Wafern eines Waferstacks gebildet werden. Somit kann die Anschlussöffnung in Ausführungsformen, die nur einen Wafer behandeln, als auch in Ausführungsformen, in denen ein Waferstack bevorzugt ist, bereitgestellt werden.

Durch die Anschlussöffnung wird eine (vorzugsweise interne) elektrische Verbindung an den Durchkontaktierungsbereich bereitgestellt, welche eine Kontaktierung des MEMS-Bauteils oder der elektronischen Schaltung mit dem Durchkontaktierungsbereich erlaubt. Die Anschlussöffnung kann dabei in einem Wafer und/oder einem Waferstack gebildet werden. Bevorzugt sind hierfür die obig genannten Ätzverfahren. Durch die Ätzverfahren wird eine Kavität gebildet, die vorzugsweise bis zum Durchkontaktierungsbereich reicht. Weiterhin kann es bevorzugt sein, dass die Anschlussöffnung in den Durchkontaktierungsbereich hinein reicht.

Da der Durchkontaktierungsbereich einen vertikalen Abschnitt darstellt, um zwischen verschiedenen Leiterbahnebenen elektrischen Strom zu leiten, weist der Durchkontaktierungsbereich bevorzugt zwei Anschlussbereiche auf, die für einen Betrieb elektrisch kontaktiert und geschlossen werden müssen, um einen Stromkreis zu bilden. Bevorzugt wird einer erster (interner) Anschlussbereiche durch eine Anschlussöffnung bzw. durch Befüllung der Anschlussöffnung mit einem elektrisch leitfähigen Material gebildet und ein zweiter (externer) Anschlussbereich durch ein Anschlusspad für eine externe Kontaktierung des Halbleiterbauteils. Beide Anschlussbereiche sind bevorzugt Bestandteil der elektrischen Verbindung zum Betrieb des MEMS-Bauteils und/oder der elektronischen Schaltung.

In einer weiteren Ausführungsform ist das Verfahren dadurch gekennzeichnet, dass es sich bei dem leitfähigen Material für die Anschlussöffnung um ein Metall oder ein Halbleitermaterial, bevorzugt Monosilizium oder Polysilizium, handelt.

Durch die Befüllung der Anschlussöffnung mit einem leitfähigen Material kann die elektrische Verbindung zwischen der Anschlussöffnung und dem Durchkontaktierungsbereich hergestellt werden. Dabei sind Metalle und/oder Halbleitermaterialien geeignet, um eine elektrische Verbindung darzustellen. Sie sind in ihrer Herstellung kosten- und aufwandsgünstig und weisen einen hohen Wirkungsgrad auf.

In einer weiteren Ausführungsform ist das Verfahren dadurch gekennzeichnet, dass auf einer Kontaktierungsseite des Wafers oder Waferstacks auf dem Durchkontaktierungsbereich ein Anschlusspad angebracht wird, wobei zu diesem Zweck bevorzugt zunächst eine Isolierschicht unter zumindest teilweisem Auslassen des Durchkontaktierungsbereiches auf den Wafer oder den Waferstack aufgebracht wird und durch Füllen des ausgelassenen Bereiches mit einem leitfähigen Material das Anschlusspad gebildet wird.

Durch die Bildung des Anschlusspads wird ein zweiter (externer) Anschlussbereich zur elektrischen Verbindung des Durchkontaktierungsbereiches bereitgestellt, um einen geschlossenen Stromkreis für den Betrieb des MEMS-Bauteils und/oder der elektronischen Schaltung zu bilden. Vorzugsweise wird der Anschlusspad dadurch gebildet, dass zunächst eine Isolierschicht auf eine Kontaktierungsseite des Wafers aufgetragen wird. Dabei wird die Isolierschicht bevorzugt derart beschichtet, dass der räumlich laterale Bereich des Durchkontaktierungsbereiches nicht beschichtet wird.

Es kann auch bevorzugt sein, die Kontaktierungsseite des Wafers und/oder des Waferstacks im Wesentlichen vollständig mit der Isolierschicht zu beschichten und dann anschließend im Bereich des Durchkontaktierungsbereiches zu strukturieren. Durch die Strukturierung soll die Isolierschicht im Bereich des Durchkontaktierungsbereiches entfernt werden. Damit wird eine Möglichkeit geschaffen, einen Anschlussbereich des Durchkontaktierungsbereiches elektrisch zu kontaktieren. Hierbei gebildete Strukturen können Ecken, Kanten, Vertiefungen, Senken und/oder Löcher umfassen. Durch die Isolierschicht bzw. durch das Strukturieren der Isolierschicht am Durchkontaktierungsbereich wird eine gezielte elektrische Kontaktierung mit diesem ermöglicht. Insbesondere verhindert die Isolierschicht einen elektrischen Kontakt zwischen dem Anschlusspad und anderen Bereichen des Wafers und/oder Waferstacks, sodass Kurzschlüsse vermieden werden.

Durch Ausfüllen der ausgelassenen Stelle des Durchkontaktierungsbereiches mit einem elektrisch leitfähigen Material wird ein Anschlusspad gebildet, sodass der Durchkontaktierungsbereich auch von dem zweiten Anschlussbereich elektrisch kontaktiert werden kann. Der Anschlusspad dient bevorzugt dazu, um mit dem Durchkontaktierungsbereich eine elektrische Verbindung herzustellen. Damit wird es ermöglicht einen Stromkreis zu schließen, um das MEMS-Bauteil und/oder die elektronische Schaltung zu betreiben.

In einer weiteren bevorzugten Ausführungsform ist das Verfahren dadurch gekennzeichnet, dass der Durchkontaktierungsbereich zwischen den vertikalen Gräben entfernt und mit einem Metall, bevorzugt Kupfer, Aluminium, Eisen, Zink, Zinn, Wolfram, Gold, deren Verbindungen und/oder Legierungen, befüllt wird.

Vorzugsweise erfolgt das Entfernen des Wafermaterials im Durchkontaktierungsbereich durch eines der oben dargestellten Ätzverfahren und das Befüllen des Durchkontaktierungsbereiches mit den genannten Materialien durch die beschrieben Beschichtungsverfahren, wobei hier das Sputtern und/oder die galvanische Abscheidung besonders bevorzugt sind.

Die genannten Materialien haben sich im Stand der Technik als sehr gute und zuverlässige elektrische Leitermaterialien bestätigt und können einfach und schnell mit den bekannten Beschichtungsmethoden in die vertikalen Gräben hineingeführt werden. Insbesondere weisen die genannten Materialien einen geringen spezifischen Widerstand auf, sodass der Strom besonders gut geleitet wird.

In einer weiteren bevorzugten Ausführungsform ist das Verfahren dadurch gekennzeichnet, dass eine Sensorstruktur für das MEMS-Bauteil in den Wafer oder in den Waferstack eingebracht wird, wobei zur Bildung der Sensorstruktur bevorzugt ein Fluorwasserstoff-Unterätzprozess (auch HF-Unterätzprozess, HF-Unterätzen oder einfach nur Unterdampfätzen, HF steht für den engl. Begriff *hydrogen fluor*) eingesetzt wird.

Das HF-Unterätzen erlaubt vorteilhaft eine Freistellung von Sensorstrukturen ohne mögliche Verklebungen des Wafers und ohne (zeit)aufwendige Ätzprozesse wie DRIE.

Im Stand der Technik sind verschiedene Ansätze und Anlagen bekannt, mit denen ein HF-Unterätzen angewendet werden kann. Beispielsweise kann es bevorzugt sein, Verfahren für ein HF-Unterätzen zu benutzen, welches in Zhang et al. (2014) beschrieben wurde.

Bevorzugt wird mit dem HF-Unterätzen eine Oxidschicht und/oder weitere Schichten des Wafers und/oder des Waferstacks und/oder des Halbleiterbauteils entfernt, um vorzugsweise freischwingende Sensorstrukturen für das MEMS-Bauteil und/oder für die elektronische Schaltung zu erhalten.

Sensorstrukturen bezeichnen bevorzugt Bauelemente und/oder Abschnitte eines Wafers oder eines Waferstacks, die für das MEMS-Bauteil ausgestaltet sind. Sie können bevorzugt mechanische und/oder elektrische Informationen verarbeiten und für Sensoren und Aktoren, aber auch Oszillatoren und Filter geeignet sein. Die Sensorstrukturen können charakteristische Abmaße im Mikrometerbereich, aber auch darüber hinaus, aufweisen. Durch die im Stand der Technik bekannten Möglichkeiten lassen sich Sensorstrukturen einfach, kostengünstig und massentauglich herstellen.

In einer weiteren bevorzugten Ausführungsform ist das Verfahren dadurch gekennzeichnet, dass das Halbleiterbauteil ein MEMS-Bauteil und/oder eine elektronische Schaltung aufweist, wobei das MEMS-Bauteil ein Beschleunigungssensor, ein Gyroskop, ein Drucksensor, ein Mikrofon, ein Strömungssensor und/oder ein Gassensor und/oder die elektronische Schaltung, ein Hochfrequenzbauelement, eine integrierte Ausleseschaltung und/oder einen Verstärker umfasst.

MEMS-Bauteile bieten gegenüber konventionellen makroskopischen Systemen vor allem Vorteile in der Kostenersparnis, beispielsweise durch einen deutlich geringeren Verbrauch an Werkstoffen und/oder der parallelen Fertigung von mehreren MEMS-Bauteilen, und in der Effizienz, beispielsweise durch einen geringeren Energie- und Leistungsbedarf. Zudem bieten sie ein großes Funktionsspektrum, hohe Funktionsdichten und neue Funktionalitäten. Die Integration und Miniaturisierung führen zu kurzen Informationswege und kurzen Reaktionszeiten. Außerdem weisen sie eine höhere Zuverlässigkeit auf, als konventionelle Systeme, vor allem durch den Wegfall von Steckern und Kabeln oder fehleranfälligen, feinmechanischen Elementen.

Ein MEMS-Bauteil umfasst bevorzugt ein miniaturisiertes Gerät, eine Baugruppe und/oder ein Bauteil, dessen Komponenten kleinste Abmessungen im $\mu$m-Bereich haben und als System zusammenwirken. Der Einsatz von MEMS-Bauteilen ist überall dort denkbar und nach Anwendungsfall sinnvoll, wo Sensoren/Aktoren und Elektronik zusammenarbeiten.

Ein Beschleunigungssensor misst in der Regel mit einer Positionsmess-Schaltung die Verschiebung einer Prüfmasse. Für die digitale Weiterverarbeitung wird das gemessene Signal beispielsweise mithilfe eines A/D-Wandlers in eine digitale Information umgewandelt. Da die Beschleunigung der Prüfmasse direkt proportional zu der auf den Körper wirkenden Kraft ist, kann die Beschleunigung indirekt über eine Kraft gemessen werden, die auf eine der Achsen des Beschleunigungssensors wirkt. Beschleunigungssensoren umfassen vorzugsweise Bohrungen, Hohlräume, Federn und Kanälen, die mithilfe von im Stand der Technik bekannten Mikrobearbeitungsverfahren angefertigt werden. Die Beschleunigungskräfte können anhand der Verschiebung der Prüfmasse in Bezug auf feststehende Elektroden gemessen werden.

Ein verbreitetes Messverfahren, das in Beschleunigungssensoren zum Einsatz kommt, ist kapazitiver Natur. Die Beschleunigung wird dabei als Kapazitätsänderung der beweglichen Prüfmasse erfasst. Typisch für diese Technik sind ihre hohe Genauigkeit und Stabilität, die geringe Verlustleistung und die einfach herzustellende Struktur. Ihre Anfälligkeit gegenüber Rauschen und Temperaturschwankungen ist gering. Die durch Beschleunigung hervorgerufene, im Mikrometerbereich liegende Verschiebung der beweglichen Masse bewirkt eine extrem geringe Kapazitätsänderung, die es zu erfassen gilt. Dies bedingt die Verwendung einer großen Zahl beweglicher Massen und feststehender Elektroden, die parallelgeschaltet werden. Diese Anordnung ergibt eine höhere Kapazitätsänderung, die sich präziser erfassen lässt und die kapazitive Technik insgesamt praktikabler macht. Die erfindungsgemäße Reduktion parasitäre Kapazitäten kann somit insbesondere zu besseren Messergebnissen für derartige Verfahren führen.

Gyroskope (in Kurzform auch nur Gyros genannt) sind Bauteile, die Drehbewegungen messen oder beibehalten. Sie sind kompakte kostengünstige Sensoren, die die Winkelgeschwindigkeit messen. Die Einheiten der Winkelgeschwindigkeit werden in Grad pro Sekunde (° / s) oder Umdrehungen pro Sekunde (RPS) gemessen. Gyroskope können zur Bestimmung der Orientierung verwendet werden und sind in den meisten autonomen Navigationssystemen zu finden. Bei einer Rotation wird eine kleine Prüfmasse verschoben, wenn sich die Winkelgeschwindigkeit ändert. Diese Bewegung wird in sehr schwache elektrische Signale umgewandelt, die beispielsweise von einem Mikrocontroller verstärkt und gelesen werden können. Das Funktionsprinzip vieler bekannter Gyroskope ist, wie beim im obigen Abschnitt zu Beschleunigungssensoren aufgeführt, kapazitiver Natur.

Drucksensoren umfassen beispielsweise auf einem Wafer oder einem Mikrochip angebrachte Kondensatoren, die zum Beispiel über die Sensorstruktur gebildet werden können. Bei einer Druckbeaufschlagung werden die Abstände der Sensorstrukturen und damit auch die Kapazitäten verändert. Dieses Funktionsprinzip ist ebenfalls kapazitiv. Allerdings können Drucksensoren auch auf anderen physikalischen Prinzipien beruhen. So sind beispielsweise induktive Drucksensoren, piezoresistiven Drucksensoren oder auch Drucksensoren, welche auf den Hall-Effekt basieren.

Ein MEMS-Mikrofon bezeichnet bevorzugt ein Mikrofon, dessen klangerzeugende oder klangaufnehmenden Strukturen mindestens teilweise eine Dimensionierung im Mikrometerbereich (1 $\mu$m bis 1000 $\mu$m) aufweisen. Bevorzugt kann eine schwingfähige Membran in Breite, Höhe und/oder Dicke eine Dimension im Bereich von weniger als 1000 $\mu$m aufweisen.

Die schwingfähige Membran ist bevorzugt zur Erzeugung oder Aufnahme von Druckwellen des Fluids eingerichtet. Bei dem Fluid kann es sich sowohl um ein gasförmiges als auch flüssiges Fluid handeln, bevorzugt handelt es sich um Schalldruckwellen. Ein MEMS-Mikrofon wandelt mithin bevorzugt Druckwellen (z.B. akustische Signale als Schallwechseldrücke) in elektrische Signale um. Mittels der elektronischen Schaltung können bevorzugt die Schwingungen der schwingfähigen Membran durch piezoelektrische, piezoresistive und/oder kapazitive Komponenten und/oder Effekte ausgelesen werden.

Strömungssensoren dienen zur Erfassung des Durchflusses von Fluidströmungen. Strömungssensoren können auf thermische und nicht-thermische Prinzipien beruhen. Die im Stand der Technik am häufigsten vorkommenden nicht-thermischen Strömungssensoren sind die sogenannten Drag Force Sensoren, Pressure Drop Sensoren und Coriolis Sensoren.

Das thermische Prinzip basiert auf der konvektiven Wärmeübertragung eines elektrisch beheizten Widerstandes in das vorbeiströmende Fluid, welche in Abhängigkeit der Flussrate zum Abkühlen des Heizers führt und somit elektrisch erfasst werden kann. Da der konvektive Wärmetransport direkt proportional zum Massenfluss ist, handelt es sich bei diesen Sensoren um Massenflusssensoren. Es gibt prinzipiell drei verschiedene Arten von Strömungssensoren, nämlichen Hitzdraht- bzw. Heißfilmsensoren (thermische Anemometer), Kalorimetrische Sensoren und Time-of-Flight Sensoren.

Ein Gassensor ist für die Detektion gasförmiger Substanzen verantwortlich. Der Anteil bestimmter chemischer Inhaltsstoffe des Gases wird vom Sensor in ein elektrisches Signal umgewandelt, beispielsweise durch die elektronische Schaltung.

Ein Hochfrequenzbauelement ist bevorzugt ein Bauelement, welches elektrische und/oder elektromagnetische Signale mit Frequenzen im Hochfrequenzbereich überträgt, empfängt, blockiert und/oder durchlässt. Im Stand der Technik ist der Begriff der Hochfrequenz tatsächlich nicht einheitlich definiert. Hierfür können Frequenzen bereits ab ca. 1 kHz (Kilohertz) in Frage kommen, aber auch Frequenzen im MHz- (Megahertz), GHz- (Gigahertz) und/oder THz-Bereich (Terahertz). Als Hochfrequenzbauelement können digitale Filter, analoge Filter, Verstärker, Antennen, Bias-Netzwerke, Richtkoppler, Absorberelemente, Wellenleiter und/oder Verteilernetzwerke eingesetzt werden.

Ausleseschaltungen umfassen bevorzugt Schaltungsmaßnahmen, die das Halbleiterbauteil und/oder das MEMS-Bauteil konditionieren, z. B. bei der Kompensation von bestimmten Strömen oder bei Rauschunterdrückung. Ausleseschaltungen können auch elektrische Signale in bestimmter Weise aufbereiten, beispielsweise durch Logarithmierung, Verstärkung, oder Impedanzwandlung. All diese Maßnahmen tragen dazu bei, ein elektrisches Signal in geeigneter Form auszulesen und es einer darauffolgenden Schaltung zur Verfügung zu stellen. Im einfachen Fall kann die darauffolgende Schaltung eine Treiberschaltung für die Ausgabe des Signals an einem Chipausgang sein.

Ein Verstärker formt ein eingespeistes Signal derart, dass der zeitliche Verlauf dieses Eingangssignals nachgebildet wird, jedoch mit höherer Leistung. Ein Verstärker erzeugt also ein "stärkeres Abbild" eines schwachen Eingangssignals, indem er im Wesentlichen als elektrisch steuerbarer Widerstand arbeitet: Bei einem geringen Eingangssignal setzt er der Spannung aus der Energiequelle einen hohen Widerstand entgegen, so dass diese relativ stark abgeschwächt wird; bei höherem Eingangssignal stellt er einen geringeren Widerstand dar, so dass die Energie relativ ungehindert fließen kann.

Eine speziellere Klasse von Verstärkern stellen auch sogenannte Schaltverstärker dar, die im erfindungsgemäßen Halbleiterbauteil eingebaut werden können. Schaltverstärker können mit geringer Leistung einen meist erheblich größeren Strom (oder Spannung) ein- und ausschalten. Damit ist oft auch eine Potentialtrennung verbunden, z. B. wenn Netzspannungen geschaltet werden.

Die erfindungsgemäße Bereitstellung einer Durchkontaktierung mit überaus geringen parasitären Kapazitäten, wirkt sich vorteilhaft für die verschiedensten genannten Halbleiterbauteile aus.

In einer weiteren bevorzugten Ausführungsform ist das Verfahren dadurch gekennzeichnet, dass das Halbleiterbauteil mit einem MEMS-Bauteil und/oder einer elektronischen Schaltung mittels einer Die-Attach-Technologie, Flip-Chip-Technologie, Durchsteckmontage, Oberflächenmontage, Bondtechnologie, Laserschweißen, Heißsiegeltechnologie, Fügeprozessen, Kleben und/oder Löten verbunden wird.

Die genannten Verbindungs- und Montagetechniken haben sich im Stand der Technik als besonders zuverlässig, robust und einfach herausgestellt. Insbesondere können elektronische und nichtelektronische (Mikro-)Komponenten miteinander besonders gut verknüpft werden.

In einem weiteren Aspekt betrifft die Erfindung ein Halbleiterbauteil hergestellt gemäß dem erfindungsgemäßen Verfahren.

Der durchschnittliche Fachmann erkennt, dass technische Merkmale, Definitionen und Vorteile bevorzugter Ausführungsformen welche für das erfindungsgemäßen Verfahren zur Herstellung einer Durchkontaktierung für ein Halbleiterbauteil gleichermaßen für das erfindungsgemäß herstellbare Halbleiterbauteil mit einer Durchkontaktierung gelten, und umgekehrt.

Das Halbleiterbauteil weist einen Durchkontaktierungsbereich auf, welcher Strom zwischen verschiedenen vertikalen Leiterbahnebenen transportiert. Vertikale Gräben umschließen den Durchkontaktierungsbereich, die für eine Isolierung des Durchkontaktierungsbereiches sorgen. Bevorzugt sind die vertikalen Gräben mit einem Dielektrikum partiell befüllt und/oder die Wände und der Boden der vertikalen Gräben sind mit einem Dielektrikum ausgekleidet. Dies hat sich als besonders vorteilhaft erwiesen, da auftretende parasitäre Kapazitäten erheblich verringert werden.

Zudem ist der Durchkontaktierungsbereich durch vertikale Gräben hermetisch abgeriegelt und die vertikalen Gräben werden bevorzugt derart mit dem Dielektrikum befüllt, dass sie auch selbst hermetisch abgeriegelt sind. Damit ergibt sich ein besonders guter Schutz des Durchkontaktierungsbereiches und der vertikalen Gräben gegenüber der Umgebung des Halbleiterbauteils oder anderen Abschnitten des Halbleiterbauteils selbst. Zudem wird der Durchkontaktierungsbereich derart ausgebildet, dass vorteilhafterweise ein minimaler Innenwiderstand vorliegt. Das liegt unter anderem daran, dass auch der Durchkontaktierungsbereich vorteilhaft eine geringe laterale Aufweitung besitzt. Die geringe laterale Aufweitung des Durchkontaktierungsbereich wird beispielsweise dadurch realisiert, dass die vertikalen Gräben einen Mund und einen Bauch umfassen und der Bauch lateral aufgeweitet ist, sodass der Durchkontaktierungsbereich lateral eingeschränkt wird.

Weiterhin können durch die geringen Abmessungen des Durchkontaktierungsbereiches dieser besonders gut und besonders einfach mit Kavitäten innerhalb eines Wafers oder eines Waferstacks, indem sich bevorzugt ein MEMS-Bauteil und/oder eine elektronische Schaltung befindet, verbunden werden.

Das erfindungsgemäße Verfahren soll im Folgenden anhand von Beispielen näher erläutert werden, ohne auf diese Beispiele beschränkt zu sein.

## FIGUREN

Kurzbeschreibung der Abbildungen

Fig. 1 A - Q    Darstellung von bevorzugten Verfahrensschritten gemäß einer ersten Ausführungsform der Erfindung

Fig. 2 A - D    Darstellung von bevorzugten Verfahrensschritten gemäß einer zweiten Ausführungsform der Erfindung

Fig. 3 A - F    Darstellung von bevorzugten Verfahrensschritten gemäß einer dritten Ausführungsform der Erfindung

Detaillierte Beschreibung der Abbildungen

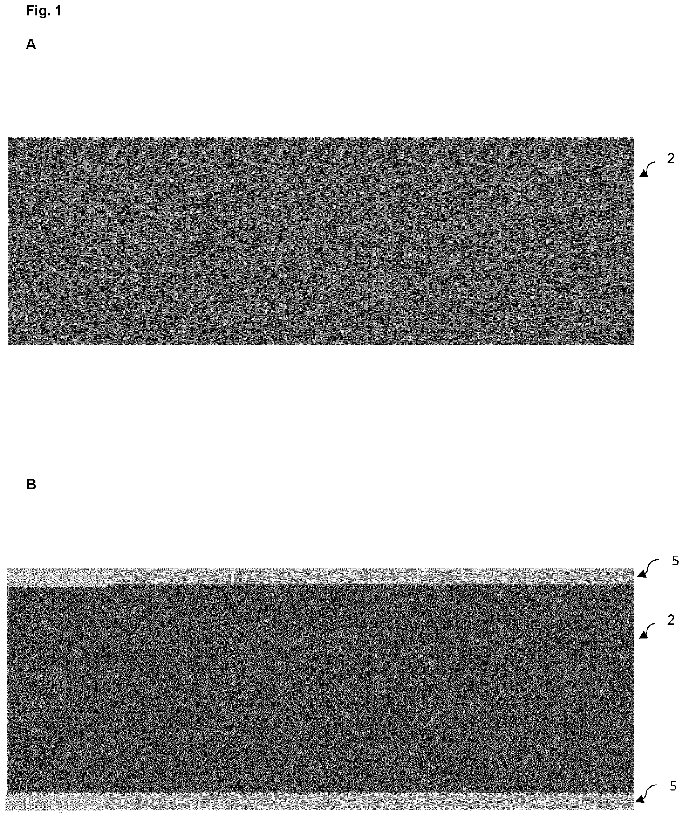

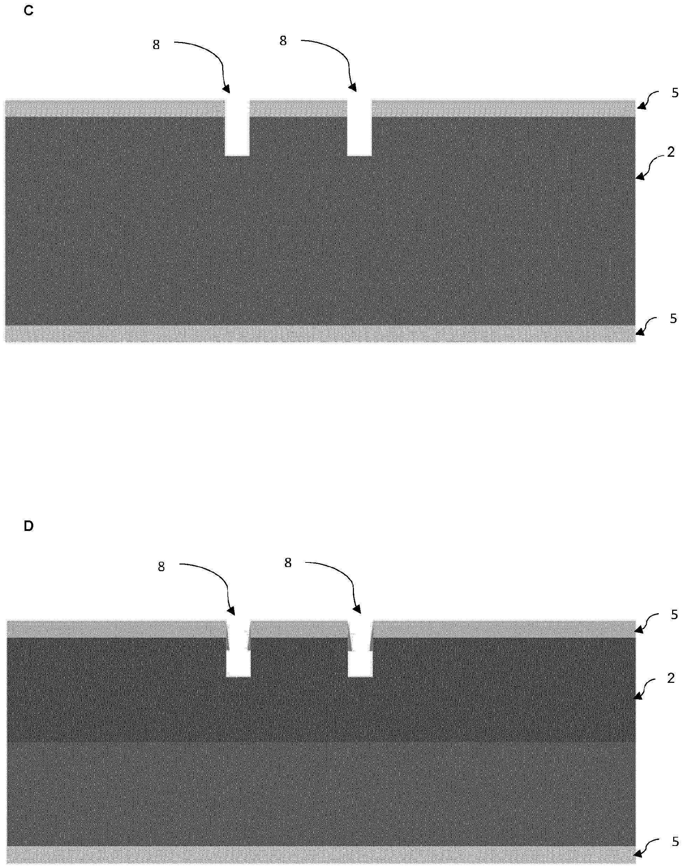

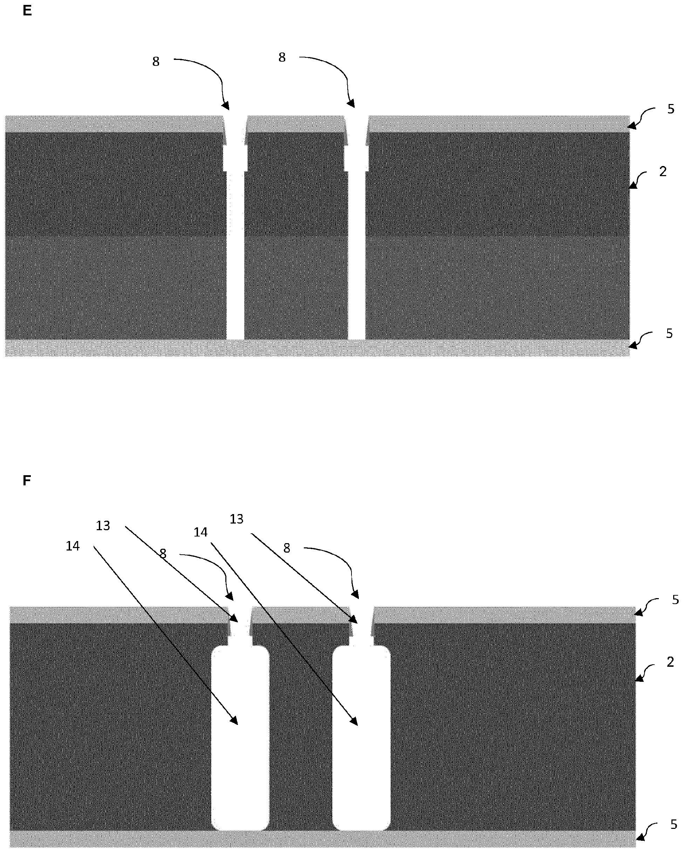

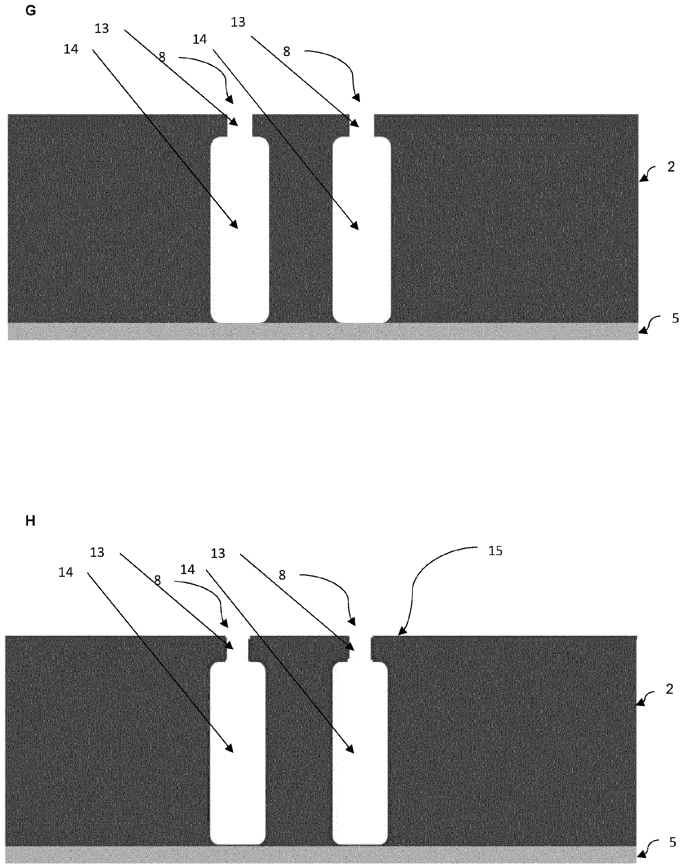

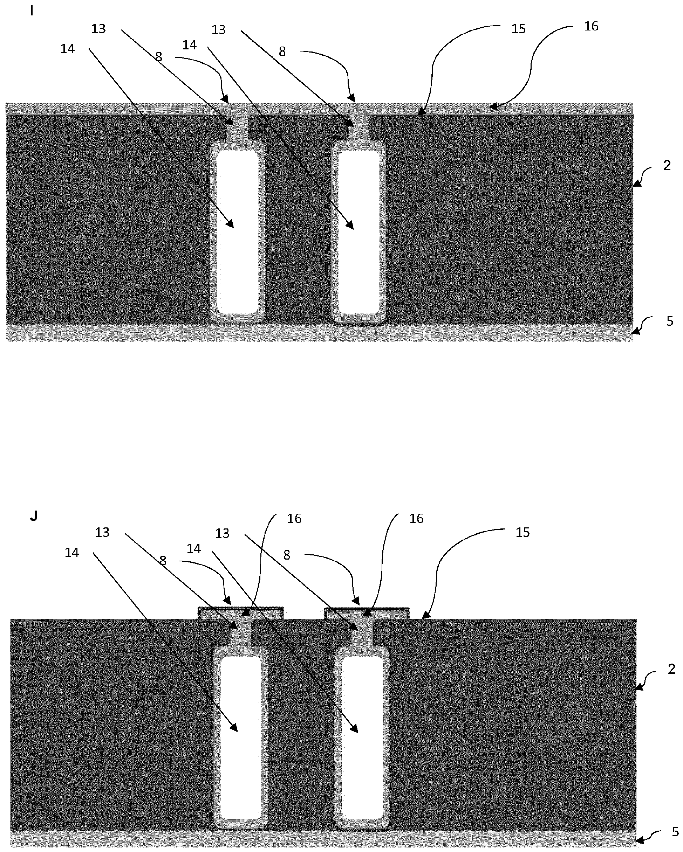

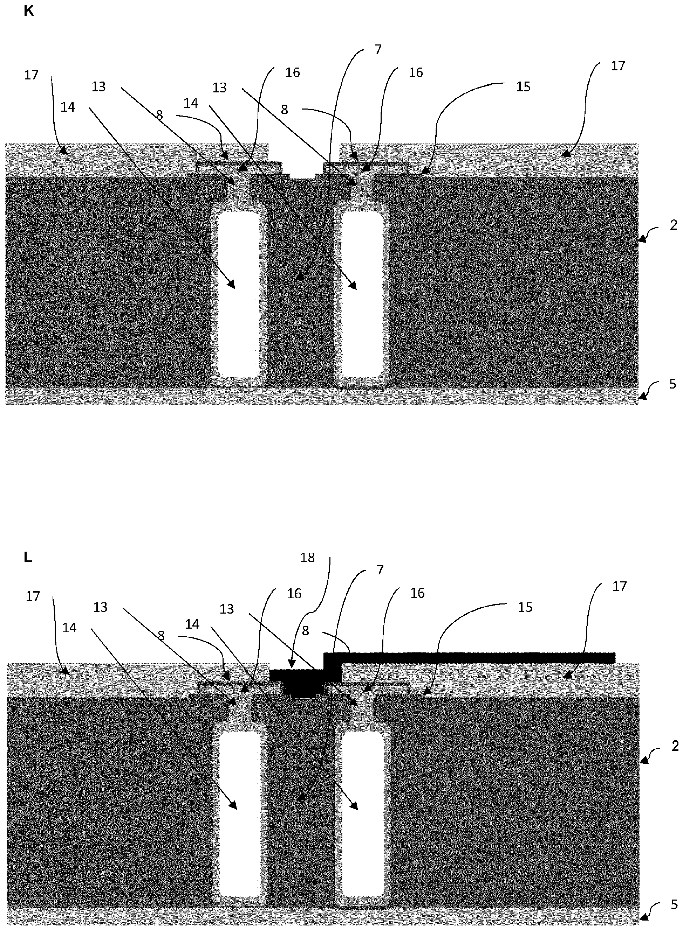

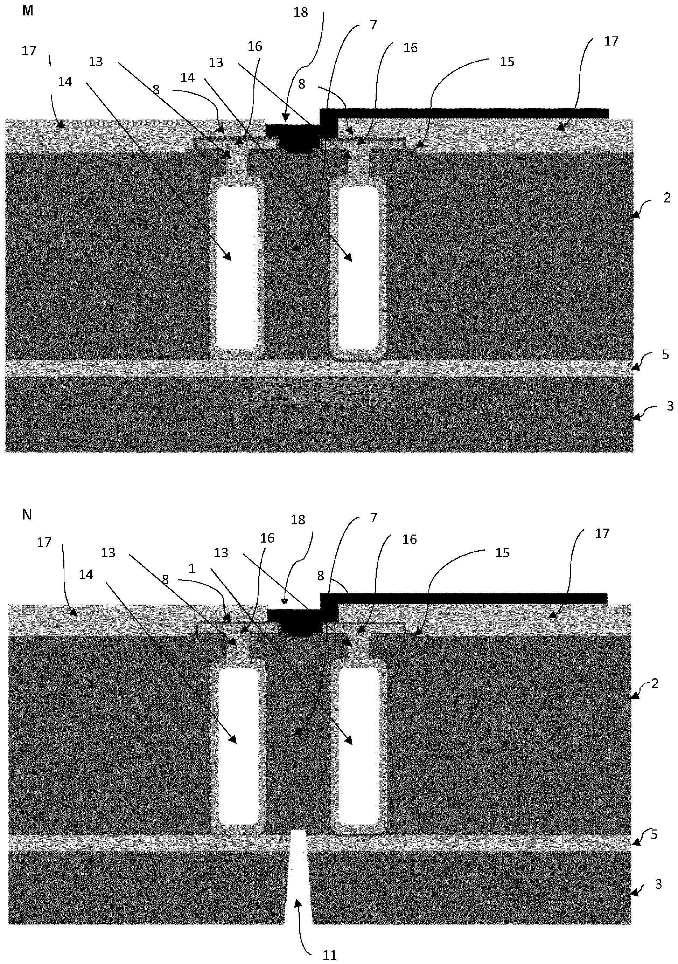

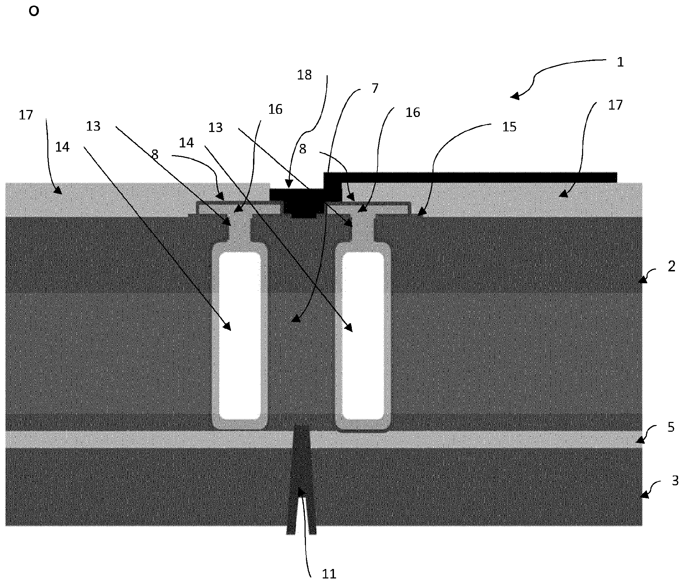

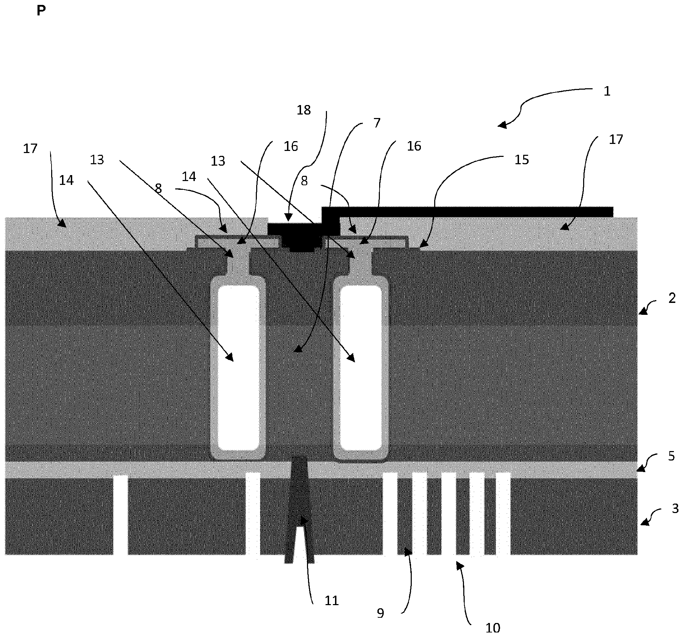

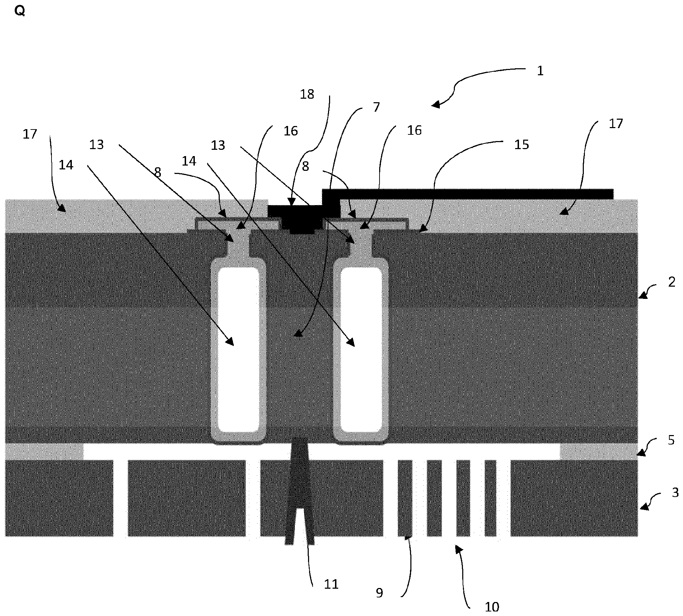

**Fig. 1** zeigt eine Darstellung von bevorzugten Verfahrensschritten A - Q einer ersten Ausführungsform des erfindungsgemäßen Verfahrens. Wie obig erläutert, wird ein Halbleiterbauteil **1** hergestellt mit einem Durchkontaktierungsbereich **7,** der sich insbesondere aufgrund minimaler parasitärer Kapazitäten und der gleichzeitigen hermetischen Abriegelung des Durchkontaktierungsbereiches **7** als besonders vorteilhaft erwiesen hat.

Zur Herstellung des Halbleiterbauteils **1** wird in Verfahrensschritt **A** zunächst ein erster Wafer **2** bereitgestellt.

In Verfahrensschritt **B** wird eine Oxidschicht **5** auf eine Vorder- und eine Rückseite des ersten Wafers **2** gebracht, um den ersten Wafer **2** in gezielten Bereichen zu bearbeiten und entsprechend andere Bereich vor Ätzprozessen zu schützen. Insbesondere stellt die Vorderseite eine Kontaktseite des Halbleiterbauteils dar. Die Oxidschicht **5** wird in Verfahrensschritt **B** mit "Oxide hard mask" bezeichnet.

In Verfahrensschritt **C** werden vertikale Gräben **8** mithilfe eines Ätzprozesses in den ersten Wafer **2** eingeführt. In diesem Schritt können die vertikalen Gräben **8** zunächst beispielsweise eine Breite von ca. 5 μm und

eine Tiefe von ca. 10 μm aufweisen.

In Verfahrensschritt **D** werden Seitenwände der vertikalen Gräben oder ein Teil der Seitenwände der vertikalen Gräben **8** mit einer Linienschicht ausgekleidet. Die Linienschicht kann beispielsweise ein Oxid und/oder TEOS umfassen. Diese Linienschicht dient ebenfalls zum Schutz des Wafers vor weiteren Ätzprozessen, die in den nachfolgenden Verfahrensschritten stattfinden.

In Verfahrensschritt **E** werden die vertikalen Gräben **8** ausgebildet über weitere Ätzprozesse. Bevorzugt reichen die vertikalen Gräben **8** bis zur Oxidschicht auf der Rückseite des ersten Wafers **2.**

In Verfahrensschritt **F** werden die vertikalen Gräben **8** mit weiteren Ätzprozessen, wie beispielsweise nasschemischen Ätzen oder Trockenätzen, bearbeitet, sodass sie einen Mund **13** und einen Bauch **14** aufweisen. Der Bauch **14** bildet sich über eine laterale Aufweitung der vertikalen Gräben **8**. Die Bildung des Bauches **14** ist von Vorteil, da einerseits der Durchkontaktierungsbereich **7** lateral verringert wird und andererseits der Abstand des Durchkontaktierungsbereiches **7** beispielsweise mit anderen Durchkontaktierungsbereichen, die nicht abgebildet sind, einen höheren Abstand gewinnt, um auftretende parasitäre Kapazitäten zu verringern. Zudem wird das Verhältnis aus Fläche und Abstand gemäß Gleichung (1) mit diesem Verfahrensschritt so gebildet, dass der Innenwiderstand des Durchkontaktierungsbereich vorteilhafterweise verringert wird.

In Verfahrensschritt **G** wird optional die Oxidschicht **5** auf der Vorderseite des ersten Wafers **2** entfernt. Ebenso wird in diesem Verfahrensschritt die Linienschicht entfernt.

In Verfahrensschritt **H** wird der erste Wafer **2,** insbesondere die vertikalen Gräben **8** mit einer

Siegelschicht **15** versehen. Die Siegelschicht **15** schützt vorteilhafterweise die vertikalen Gräben **8** und/oder den ersten Wafer **2** vor Unterdampfätzprozessen, die in den nachfolgenden Schritten stattfinden. Zudem ergibt sich mit der Siegelschicht **15** in Kombination mit einem Dielektrikum **16** eine besonders gute hermetische Abriegelung des Durchkontaktierungsbereiches **7** und der vertikalen Gräben **8**. Die Siegelschicht **15** kann beispielsweise Siliziumnitrid und/oder Siliziumoxinitrid sein.

In Verfahrensschritt **I** werden die vertikalen Gräben **8** mit dem Dielektrikum **16** befüllt, wobei es hierbei bevorzugt ist, dass der erste Wafer **2** flächig mit dem Dielektrikum **16** beschichtet wird. Das Dielektrikum **16** kann beispielsweise TEOS und/oder Siliziumdioxid sein. Vorzugsweise wird das Dielektrikum **16** zusätzlich strukturiert, was nicht gezeigt wird, um das Dielektrikum **16** über dem Mund **13** der vertikalen Gräben zu erhalten und von weiteren Flächen des ersten Wafers **2** zu entfernen. Die vertikalen Gräben **8** werden mit dem Dielektrikum lediglich partiell befüllt. Dies kann dadurch erfolgen, dass die Seitenwände und der Boden der vertikalen Gräben **8** mit dem Dielektrikum beschichtet werden.

In Verfahrensschritt **J** findet erneut eine Beschichtung mit der Siegelschicht **15** statt, um für einen besonders guten hermetischen Verschluss der vertikalen Gräben **8** zu sorgen. Es kann dasselbe oder auch ein anderes Material umfassen. Ebenfalls nicht abgebildet, aber bevorzugt, wird die Siegelschicht **15** strukturiert, um diese lediglich über dem Mund **13** vorzufinden und einen Anschlussbereich für den Durchkontaktierungsbereich **7** zu bilden.

In Verfahrensschritt **K** wird der erste Wafer **2** mit einer Isolierschicht **17** beschichtet, wobei der Anschlussbereich des Durchkontaktierungsbereiches **7** nicht mit der Isolierschicht **17** versehen wird. Durch die Isolierschicht **17** wird ein gezielter elektrischer Kontakt zwischen einem Anschlusspad **18** und dem Durchkontaktierungsbereich **7** ermöglicht und ein unerwünschter Kontakt mit anderen Bereichen des ersten Wafers **2** vermieden, sodass beispielsweise Kurzschlüsse vermieden werden.

In Verfahrensschritt **L** wird der Anschlusspad **18**, beispielsweise ein Metall, mit dem Durchkontaktierungsbereich **7** kontaktiert.

In Verfahrensschritt **M** wird ein zweiter Wafer **3** auf der Rückseite des ersten Wafers **2** gebondet. Insbesondere bildet sich hierbei ein SOI-Wafer (gekennzeichnet durch die Aufschrift "SOI for MEMS"). SOI-Wafer haben den Vorteil, dass sie unempfindlicher gegenüber Störstrahlungen (z. B. ionisierende Strahlen) und gegenseitige Beeinträchtigung der aktiven Bauelemente ist. Zudem weist das Halbleiterbauteil **1** mit einem SOI-Wafer eine geringere Kapazität auf und kann schneller geschaltet werden. Außerdem werden geringere Verlustleistungen erzeugt.

In Verfahrensschritt **N** wird eine Anschlussöffnung **11** ausgehend von dem zweiten Wafer **3** zum Durchkontaktierungsbereich **7** des Halbleiterbauteils **1** gebildet.

In Verfahrensschritt **O** wird die Anschlussöffnung **11** mit einem leitfähigen Material befüllt, sodass sich eine elektrische Verbindung bildet und beide Anschlussbereiche des Durchkontaktierungsbereiches **7** elektrisch kontaktiert werden, um einen geschlossenen Stromkreis und somit einen Betrieb zu ermöglichen.

In Verfahrensschritt **P** werden Sensorstrukturen **9** für ein MEMS-Bauteil **10** über Ätzprozesse ausgehend von dem zweiten Wafer **3** gebildet. Die Sensorstrukturen **9** werden bis zur Oxidschicht **5** gebildet, um nicht den ersten Wafer **2** zu beschädigen.

In Verfahrensschritt **Q** wird ein Unterdampfätzprozess eingesetzt, um die Oxidschicht **5** über den Sensorstrukturen **9** zu entfernen und diese damit frei schwingbar auszugestalten, sodass, wie oben aufgeführt, diverse MEMS-Bauteile **10** realisiert werden können.

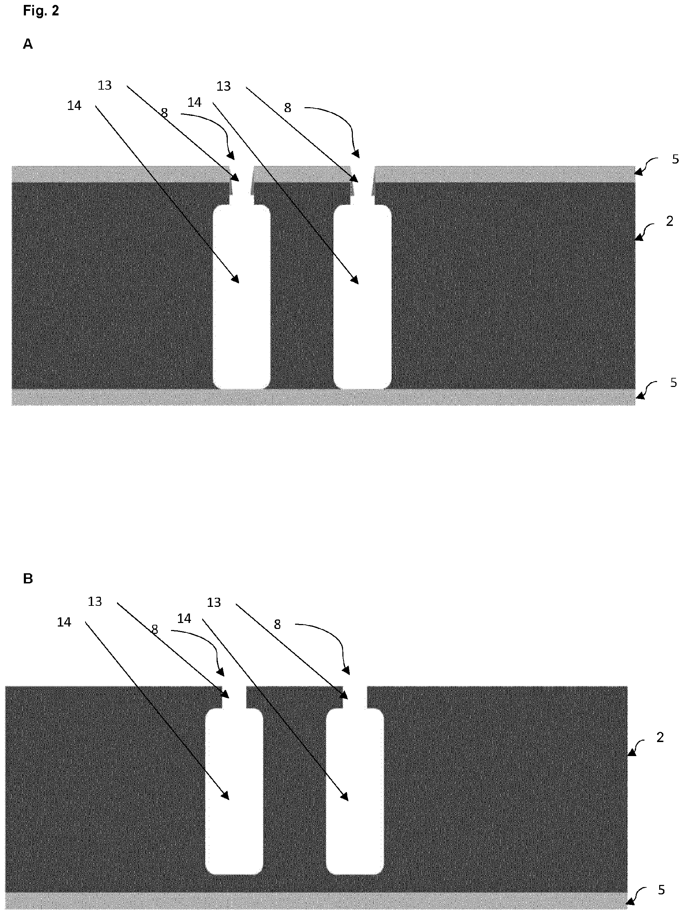

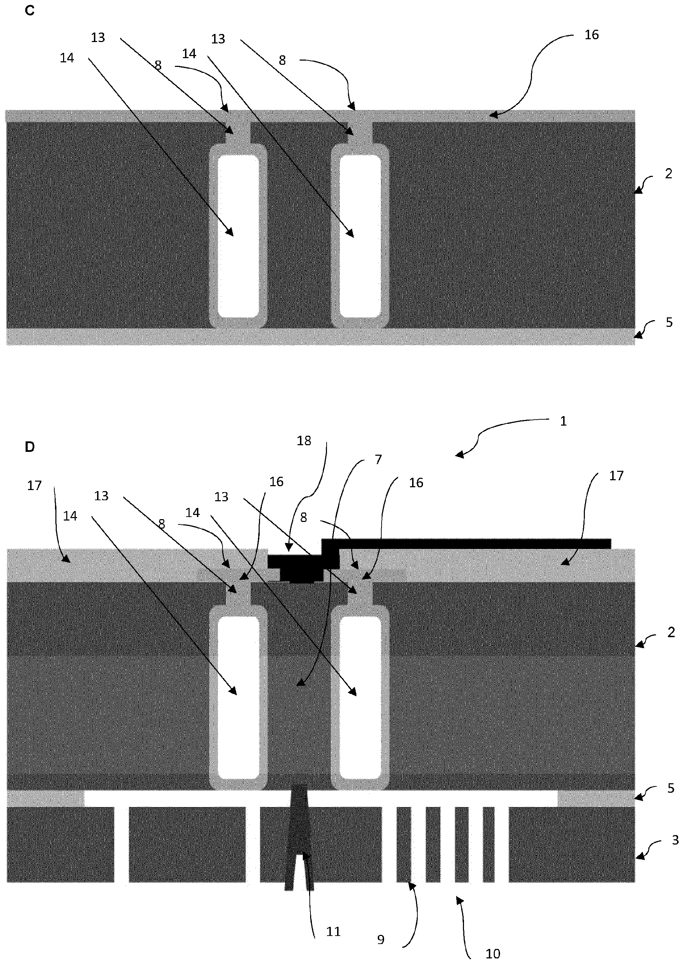

**Fig. 2** zeigt eine Darstellung von bevorzugten Verfahrensschritten A - D einer weiteren Ausführungsform des erfindungsgemäßen Verfahrens. Die Ausführungsform gemäß **Fig. 2** verzichtet auf eine Siegelschicht **15**, stattdessen werden die vertikalen Gräben **8** "direkt" mit dem Dielektrikum **16** partiell befüllt, beispielsweise durch thermische Oxidation von Silizium.

In Verfahrensschritt **A** wird der erste Wafer **2** mit der Oxidschicht **5** auf seiner Vorder- und Rückseite bereitgestellt. Die vertikale Gräben **8** umfassen den Mund **13** und den Bauch **14**. Die hierzu durchgeführten Verfahrensschritte sind nunmehr nicht dargestellt. Optional wird in Verfahrensschritt **B** die Oxidschicht **5** auf der Vorderseite des ersten Wafers **2** und die Linienschicht am Mund **13** der vertikalen Gräben **8** entfernt. In Verfahrensschritt **C** werden die vertikalen Gräben **8** mit dem Dielektrikum **16** partiell befüllt, indem bevorzugt der erste Wafer **2** planar beschichtet wird und die Seitenwände mit dem Dielektrikum **16** beschichtet werden. Insbesondere werden die vertikalen Gräben **8** mit dem Dielektrikum **16** planar verschlossen. Durch die partielle Befüllung der vertikalen Gräben **8** bilden sich deutlich geringere parasitäre Kapazitäten und durch das planare Verschließen der vertikalen Gräben ergibt sich eine besonders gute hermetische Abriegelung der vertikalen Gräben **8** und des Durchkontaktierungsbereiches **7,** was von besonderem Vorteil ist.

In Verfahrensschritt **D** wird das fertige Halbleiterbauteil **1** dargestellt. Durch die Befüllung mit einem leitfähigen Material in die Anschlussöffnung **11** wird die elektrische Verbindung gebildet. Die elektrische Verbindung wird ebenfalls mit dem Durchkontaktierungsbereich **7** kontaktiert, um einen Betrieb des MEMS-Bauteils **10** und/oder der elektronischen Schaltung innerhalb einer Kavität des Halbleiterbauteils zu ermöglichen. Die Sensorstrukturen **9** werden frei schwingbar ausgebildet, in dem die Oxidschicht **5** über ein Unterdampfätzen entfernt wird.

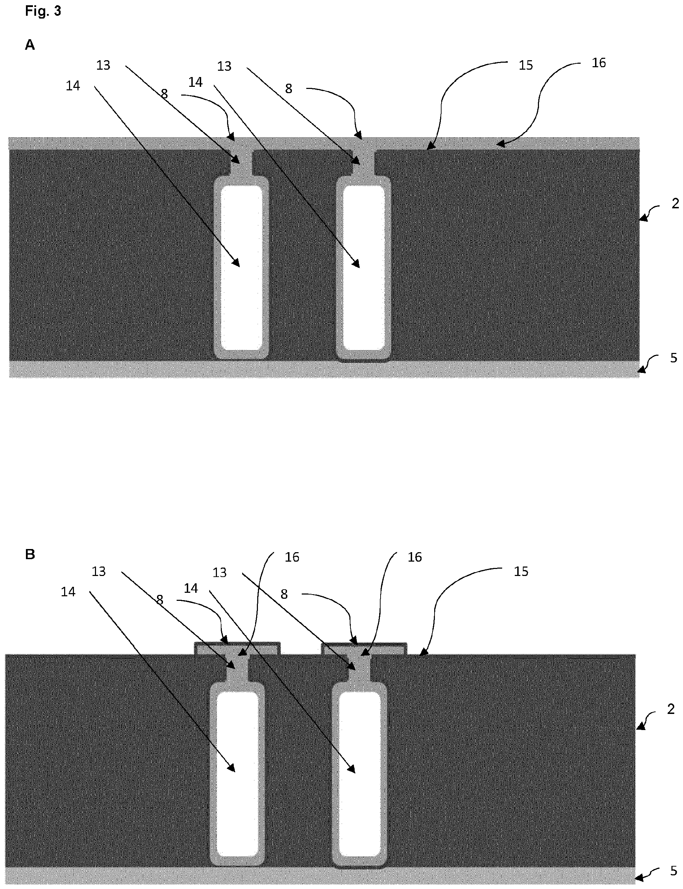

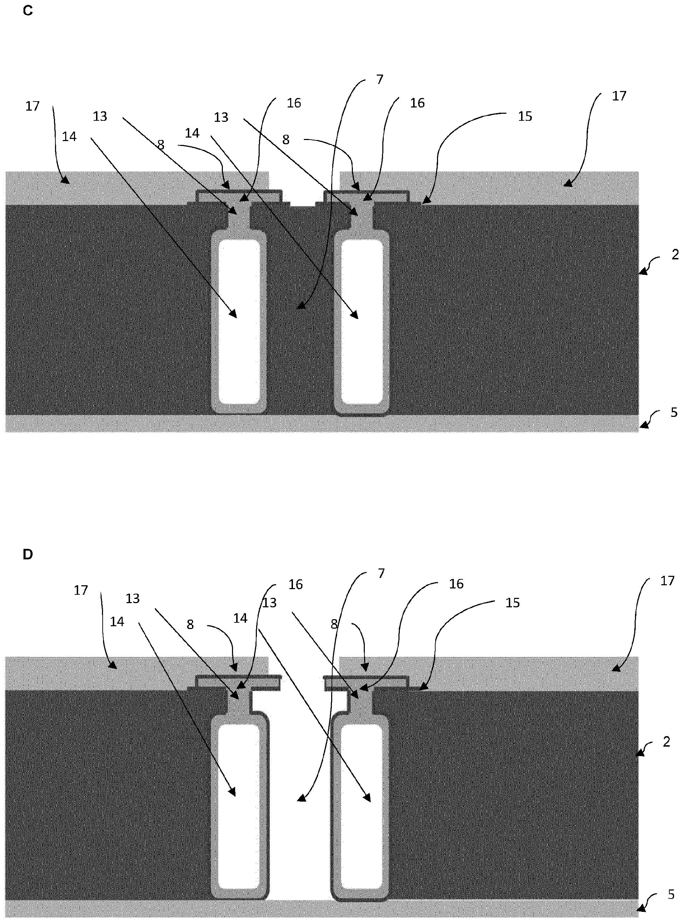

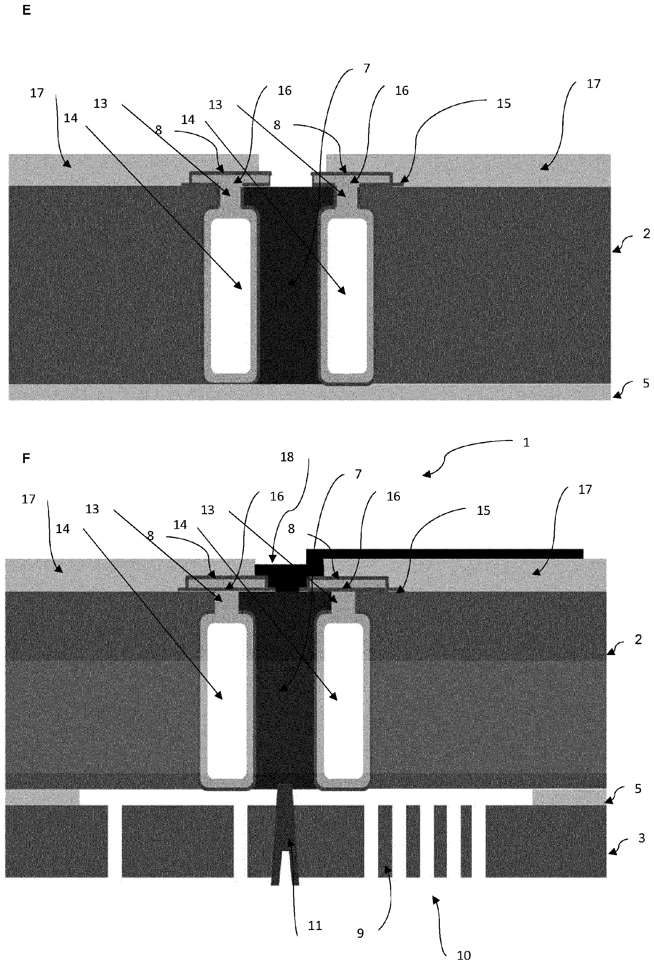

**Fig. 3** zeigt eine Darstellung von bevorzugten Verfahrensschritten A - F einer weiteren Ausführungsform der Erfindung. In der Ausführungsform gemäß **Fig. 3** wird das Material des Durchkontaktierungsbereiches **7** entfernt und mit einem Metall, beispielsweise Kupfer, Aluminium, Eisen, Zink, Zinn, Wolfram, Gold, deren Verbindungen und/oder Legierungen, befüllt.

In Verfahrensschritt **A** ist der erste Wafer **2** zu sehen, dessen vertikalen Gräben **8** der Siegelschicht **15** und dem Dielektrikum **16** bereits partiell befüllt worden sind.

In Verfahrensschritt **B** ist das Dielektrikum **16** strukturiert und der erste Wafer **2** mit einer weiteren Siegelschicht **15** beschichtet, sodass eine besondere gute hermetische Abriegelung der vertikalen Gräben **8** erfolgt.

In Verfahrensschritt **C** wird die Vorderseite des ersten Wafers **1** mit der Isolierschicht **17** beschichtet, um eine gezielte elektrische Kontaktierung des Durchkontaktierungsbereiches **7** mit einem Anschlusspad **18** zu ermöglichen.

In Verfahrensschritt **D** wird das Wafermaterial des Durchkontaktierungsbereiches **7** mithilfe eines Ätzprozesses entfernt.

In Verfahrensschritt **E** wird der Durchkontaktierungsbereich mit einem Metall befüllt. Diese Ausführungsform ist dahingehend von Vorteil, dass der Durchkontaktierungsbereich **7** einen erheblich niedrigeren inneren Widerstand aufweist.

In Verfahrensschritt F wird das fertige Halbleiterbauteil **1** gezeigt. Durch die Befüllung mit einem leitfähigen Material in die Anschlussöffnung **11** wird die elektrische Verbindung hergestellt. Der Anschlusspad **18** wird ebenfalls mit dem Durchkontaktierungsbereich **7** kontaktiert, um einen Betrieb des MEMS-Bauteils **10** und/oder der elektronischen Schaltung innerhalb einer Kavität zu ermöglichen. Die Sensorstrukturen **9** werden frei schwingbar ausgebildet, indem die Oxidschicht **5** mittels eines Unterdampfätzprozesses entfernt wird.

**BEZUGSZEICHENLISTE**

| 1 | Halbleiterbauteil |
|----|----|
| 2 | Erster Wafer |
| 3 | Zweiter Wafer |
| 5 | Oxidschicht |
| 7 | Durchkontaktierungsbereich |
| 8 | Vertikale Gräben |
| 9 | Sensorstruktur(en) |
| 10 | MEMS-Bauteil |
| 11 | Anschlussöffnung |
| 13 | Mund |
| 14 | Bauch |
| 15 | Siegelschicht |
| 16 | Dielektrikum |
| 17 | Isolierschicht |
| 18 | Anschlusspad |

**LITERATURVERZEICHNIS**

Zhang, Lan, et al. "Amorphous fluoropolymer protective coatings for front-side MEMS releasing by hydrofluoric acid vapor etching." Microelectronic engineering 117 (2014) 18-25

**Patentansprüche**

1. Verfahren zur Herstellung einer Durchkontaktierung für ein Halbleiterbauteil (1) umfassend mindestens einen Wafer, umfassend die nachfolgenden Schritte:

   a) Bilden von vertikalen Gräben (8) innerhalb des Wafers, welche einen Durchkontaktierungsbereich (7) umschließen
   b) Auskleiden und Verschließen der vertikalen Gräben (8) mit einem Dielektrikum (16), wobei die vertikalen Gräben (8) lediglich partiell mit dem Dielektrikum (16) befüllt werden
   c) Anschluss des Durchkontaktierungsbereiches (7) mit einer elektrischen Verbindung.

2. Verfahren nach dem vorherigen Anspruch **dadurch gekennzeichnet, dass** das Halbleiterbauteil (1) ein MEMS-Bauteil (10) und/oder eine elektronische Schaltung umfasst, die durch den Anschluss des Durchkontaktierungsbereiches (7) mit der elektrischen Verbindung betrieben werden.

3. Verfahren nach einem oder mehreren der vorherigen Ansprüche **dadurch gekennzeichnet, dass** der Durchkontaktierungsbereich (7) teilweise und/oder durchgängig durch den Wafer verläuft.

4. Verfahren nach einem oder mehreren der vorherigen Ansprüche **dadurch gekennzeichnet, dass** der Wafer eine Vorder- und Rückseite aufweist, wobei die Durchkontaktierung von der Vorder- zur Rückseite geführt wird, wobei besonders bevorzugt sich rückseitig ein MEMS-Bauteil (10) und/oder eine elektronische Schaltung befindet, welche durch Anschluss mit dem Durchkontaktierungsbereich (7) kontaktiert werden.

5. Verfahren nach dem vorherigen Anspruch **dadurch gekennzeichnet, dass** das Halbleiterbauelement (1) eine Kavität aufweist, in der ein MEMS-Bauteil (10) und/oder eine elektronische Schaltung vorliegt, wobei sich die Kavität bevorzugt innerhalb eines von mindestens zwei Wafern (2, 3) gebildeten Waferstacks befindet und der Durchkontaktierungsbereich (7) durch mindestens einen der beiden Wafer verläuft, wobei sich innerhalb der Kavität ein Unterdruck, vorzugsweise ein Vakuum, befindet.

6. Verfahren nach einem oder mehreren der vorherigen Ansprüche **dadurch gekennzeichnet, dass** die vertikalen Gräben (8) mit einem porösem Low-k-Dielektrikum befüllt werden, bevorzugt ausgewählt aus einer Gruppe poröse organische Materialien, poröses Kohlenstoff-dotiertes Siliziumoxid, Silikagel, Silicatische Aerogele, mesoporöses Siliziumnitrid, Polysilizium und/oder TEOS (Tetraethylorthosilicat), poröses Wasserstoff-Silsesquioxan, mesoporöse Silikatgläser, Phosphorpartikel und/oder Aluminiumoxidpartikel.

7. Verfahren nach einem oder mehreren der vorherigen Ansprüche **dadurch gekennzeichnet, dass** sich innerhalb der vertikalen Gräben (8) nach dem Verschließen ein Unterdruck, vorzugsweise ein Vakuum, befindet und/oder diese vor dem Verschließen mit einem Gas befüllt werden, welches vorzugsweise eine kleinere Dielektrizitätszahl aufweist als das Dielektrikum zum Verschließen.

8. Verfahren nach einem oder mehreren der vorherigen Ansprüche
**dadurch gekennzeichnet, dass**

die vertikalen Gräben (8) einen Mund (13) aufweisen und ausgehend von einer Breite des Mundes lateral zu einem Bauch (14) aufgeweitet sind, wobei bevorzugt die vertikalen Gräben (8) im Bereich eines Bauches (14) um mindestens 2 $\mu$m, vorzugsweise um mindestens 5 $\mu$m im Vergleich zur Breite eines Mundes (13) zusätzlich lateral aufgeweitet sind,
wobei es bevorzugt ist, dass die laterale Aufweitung weniger als 20 $\mu$m, bevorzugt weniger als 10 $\mu$m beträgt und/oder
der Mund (13) eine Tiefe von weniger als 5 $\mu$m und eine Breite von weniger als 2 $\mu$m aufweist und/oder der Bauch eine Breite von mindestens 10 $\mu$m, vorzugsweise mindestens 20 $\mu$m aufweist.

9. Verfahren nach einem oder mehreren der vorherigen Ansprüche
**dadurch gekennzeichnet, dass**

die vertikalen Gräben (8), insbesondere der Mund (13) und/oder der Bauch (14) durch nasschemische Ätzverfahren und/oder Trockenätzverfahren, bevorzugt physikalische und/oder chemische Trockenätzverfahren, besonders bevorzugt durch reaktives Ionenätzen und/oder reaktives Ionentiefenätzen (Bosch-Prozess), oder Kombination der vorgenannten Ätzverfahren gebildet werden und/oder
die vertikalen Gräben ein Aspektverhältnis bis zu 50:1 und/oder eine Tiefe zwischen 100 $\mu$m und 1000 $\mu$m aufweisen.

10. Verfahren nach einem oder mehreren der vorherigen Ansprüche
**dadurch gekennzeichnet, dass**

die vertikalen Gräben (8) mit einem Dielektrikum (16) verschlossen werden und/oder die vertikalen Gräben (8) durch eine Auskleidung mit dem Dielektrikum (16) hermetisch verschlossen werden
und/oder zum hermetischen Verschließen zusätzlich eine Siegelschicht (15) aufgebracht wird, wobei das Dielektrikum (16) zum partiellen Befüllen und Auskleiden der vertikalen Gräben und/oder die Siegelschicht (15) Siliziumnitrid, Tetraethylorthosilicat, Siliziumoxinitrid und/oder Siliziumdioxid umfasst.

11. Verfahren nach einem oder mehreren der vorherigen Ansprüche
**dadurch gekennzeichnet, dass**
zur Bereitstellung eines Anschlusses einer elektrischen Verbindung für das Betreiben des MEMS-Bauteils (10) und/oder der elektronischen Schaltung mit dem Durchkontaktierungsbereich (7) ein Bereich am Durchkontaktierungsbereich (7) mit einem leitfähigen Material kontaktiert wird oder eine Anschlussöffnung (11) in einem Wafer (3) eines Waferstacks gebildet wird, welche mit einem leitfähigen Material gefüllt wird, wobei es sich bevorzugt bei dem leitfähigen Material für die Anschlussöffnung (11) um ein Metall oder ein Halbleitermaterial, bevorzugt Monosilizium oder Polysilizium handelt.

12. Verfahren nach einem oder mehreren der vorherigen Ansprüche
**dadurch gekennzeichnet, dass**
auf einer Kontaktierungsseite des Wafers oder Waferstacks auf dem Durchkontaktierungsbereich (7) ein Anschlusspad (18) angebracht wird, wobei zu diesem Zweck bevorzugt zunächst eine Isolierschicht (17) unter zumindest teilweisem Auslassen des Durchkontaktierungsbereiches (7) auf den Wafer oder den Waferstack aufgebracht wird und durch Füllen des ausgelassenen Bereiches mit einem leitfähigen Material das Anschlusspad (18) gebildet wird.

13. Verfahren nach einem oder mehreren der vorherigen Ansprüche
**dadurch gekennzeichnet, dass**
der Durchkontaktierungsbereich (7) zwischen den vertikalen Gräben entfernt und mit einem Metall, bevorzugt Kupfer, Aluminium, Eisen, Zink, Zinn, Wolfram, Gold, deren Verbindungen und/oder Legierungen, befüllt wird.

14. Verfahren nach einem oder mehreren der vorherigen Ansprüche
**dadurch gekennzeichnet, dass**
das Halbleiterbauteil (1) ein MEMS-Bauteil (10) und/oder eine elektronische Schaltung aufweist, wobei das MEMS-Bauteil (10) ein Beschleunigungssensor, ein Gyroskop, ein Drucksensor, ein Mikrofon, ein Strömungssensor und/oder ein Gassensor und/oder die elektronische Schaltung ein Hochfrequenzbauelement, eine integrierte Ausleseschaltung und/oder einen Verstärker umfasst.

15. Halbleiter-Bauteil mit einer Durchkontaktierung hergestellt gemäß eines Verfahrens nach einem oder mehreren der vorherigen Ansprüche.

**Fig. 1**

A

2

B

5

2

5

C

8    8

5

2

5

D

8    8

5

2

5

E

F

G

14    13    8    14    13    8

2

5

H

14    13    8    14    13    8    15

2

5

K

17  13  14  16  7  16  15  17
14  8  13  8

2

5

L

17  18  16  7  16  15  17
13  14  13  8  8

2

5

**Fig. 2**

**A**

**B**

Fig. 3

A

B

E

17    14    13    8    14    13    16    7    8    16    15    17

2

5

F

18    7    1

17    14    13    8    14    13    16    8    16    15    17

2

5

3

11    9    10

Europäisches
Patentamt

European
Patent Office

Office européen
des brevets

**EUROPÄISCHER RECHERCHENBERICHT**

**Nummer der Anmeldung**

**EP 21 20 4923**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2012 200840 A1 (BOSCH GMBH ROBERT [DE]) 25. Juli 2013 (2013-07-25) | 1-5,7-15 | INV. H01L21/768 B81C1/00 H01L23/48 |
| Y | * Absätze [0033] – [0069]; Abbildungen 1-10, 12-20 * | 6 | |
| | ----- | | |
| X | DE 10 2012 219769 A1 (BOSCH GMBH ROBERT [DE]) 30. April 2014 (2014-04-30) | 1-5, 7-12,14, 15 | |
| Y | * Absätze [0028] – [0055]; Abbildungen 1, 2 * | 6 | |
| | ----- | | |
| X | DE 10 2011 085084 A1 (BOSCH GMBH ROBERT [DE]) 25. April 2013 (2013-04-25) | 1-5,7 | |
| Y | * Absätze [0026] – [0049]; Abbildungen 1,2 * | 6 | |
| | ----- | | |
| Y | US 2011/291287 A1 (WU PAUL Y [US] ET AL) 1. Dezember 2011 (2011-12-01) * Absätze [0045] – [0047]; Abbildungen 3-5 * | 6 | |
| | ----- | | |

**RECHERCHIERTE SACHGEBIETE (IPC)**

H01L
B82B
B81C

Der vorliegende Recherchenbericht wurde für alle Patentansprüche erstellt

| Recherchenort | Abschlußdatum der Recherche | Prüfer |
|---|---|---|
| **Den Haag** | **22. März 2022** | **Ploner, Guido** |

**ANHANG ZUM EUROPÄISCHEN RECHERCHENBERICHT
ÜBER DIE EUROPÄISCHE PATENTANMELDUNG NR.**

EP 21 20 4923

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

22-03-2022

| Im Recherchenbericht angeführtes Patentdokument | Datum der Veröffentlichung | Mitglied(er) der Patentfamilie | Datum der Veröffentlichung |
|---|---|---|---|
| DE 102012200840 A1 | 25-07-2013 | DE 102012200840 A1<br>US 2013189483 A1 | 25-07-2013<br>25-07-2013 |
| DE 102012219769 A1 | 30-04-2014 | CN 103794553 A<br>DE 102012219769 A1<br>TW 201428830 A<br>US 2014131888 A1 | 14-05-2014<br>30-04-2014<br>16-07-2014<br>15-05-2014 |
| DE 102011085084 A1 | 25-04-2013 | CN 103058125 A<br>DE 102011085084 A1<br>US 2013099382 A1 | 24-04-2013<br>25-04-2013<br>25-04-2013 |
| US 2011291287 A1 | 01-12-2011 | TW 201222726 A<br>US 2011291287 A1<br>WO 2011149561 A1 | 01-06-2012<br>01-12-2011<br>01-12-2011 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20050250238 A1
- US 8433084 B2
- DE 102007063742 B4

**In der Beschreibung aufgeführte Nicht-Patentliteratur**

- **ZHANG, LAN et al.** Amorphous fluoropolymer protective coatings for front-side MEMS releasing by hydrofluoric acid vapor etching. *Microelectronic engineering,* 2014, vol. 117, 18-25